# EUROPEAN PATENT APPLICATION

(11) **EP 4 819 804 A1**
(43) Date of publication of application: **07.10.2026**
(21) Application number: 24897806.6
(22) Date of filing: 12.08.2024
(51) Int. Cl.: H10H 29/01, H10H 20/813, H10H 20/831, H10H 20/84, H10H 20/857, H10H 20/00, H10H 20/855, G02B 27/01

(54) **DISPLAY PANEL, SMART GLASS COMPRISING SAME, AND MANUFACTURING METHOD THEREOF**

(30) Priority: 27.11.2023 KR 20230166872
(71) Applicant: Samsung Display Co., Ltd., Yongin-si, Gyeonggi-do 17113 (KR)
(72) Inventor: MIN, Dae Hong, Yongin-si, Gyeonggi-do 17113 (KR); KANG, Seok Jin, Yongin-si, Gyeonggi-do 17113 (KR); KIM, Su Jeong, Yongin-si, Gyeonggi-do 17113 (KR)
(74) Representative: Marks & Clerk LLP
(86) International application number: PCT/KR2024/011971
(87) International publication number: WO 2025/116205

(57) **Abstract**

A display panel, including an a-th first electrode connected to a pixel circuit of a first pixel, and electrically connected to a first emission layer in a first contact hole, a b-th first electrode connected to a pixel circuit of a second pixel, and electrically connected to a second emission layer in a second contact hole formed by removing at least a portion of the first emission layer, a c-th first electrode connected to a pixel circuit of a third pixel, and electrically connected to a third emission layer in a third contact hole formed by removing at least portions of the first and second emission layers, and a second electrode connected to the pixel circuits of the first to third pixels, and connected to the first to third emission layers in a fourth contact hole formed by removing at least portions of the first to third emission layers.

## Description

### Technical Field

Various embodiments of the disclosure relate to a display panel, smart glasses including the display panel, and a method of fabricating the display panel.

### Background Art

With the development of information technology, the importance of a display device, which is a connection medium between a user and information, has been emphasized. Owing to the importance of display devices, the use of various kinds of display devices, such as a liquid crystal display device and an organic light-emitting display device, has increased.

As display devices display images in areas close to the eyes of a user, high-resolution and thin display devices (or display panels) are needed.

It is to be understood that this background of the technology section is, in part, intended to provide useful background for understanding the technology. However, this background of the technology section may also include ideas, concepts, or recognitions that were not part of what was known or appreciated by those skilled in the pertinent art prior to a corresponding effective filing date of the subject matter disclosed herein.

### Detailed Description of Invention

### Technical Problem

Various embodiments of the disclosure are directed to a display panel capable of displaying a high-resolution image, smart glasses including the display panel, and a method of fabricating the display panel.

Various embodiments of the disclosure are directed to a thin display panel, smart glasses including the display panel, and a method of fabricating the display panel.

### Technical Solution

An embodiment of the disclosure may provide a display panel including a substrate on which a first pixel that emits light in a first wavelength band, a second pixel that emits light in a second wavelength band, and a third pixel that emits light in a third wavelength band are disposed, each of the first to third pixels including a pixel circuit. The display panel may further include a first emission layer disposed on the substrate, and that emits light in the first wavelength band, a second emission layer disposed on the first emission layer, and that emits light in the second wavelength band, and a third emission layer disposed on the second emission layer, and that emits light in the third wavelength band. The display panel may further include an a-th first electrode electrically connected to the pixel circuit of the first pixel, and electrically connected to the first emission layer in a first contact hole, a b-th first electrode electrically connected to the pixel circuit of the second pixel, and electrically connected to the second emission layer in a second contact hole formed by removing at least a portion of the first emission layer, a c-th first electrode electrically connected to the pixel circuit of the third pixel, and electrically connected to the third emission layer in a third contact hole formed by removing at least respective portions of the first and the second emission layers, and a second electrode electrically connected to the pixel circuit of each of the first to the third pixels, and electrically connected to the first to the third emission layers in a fourth contact hole formed by removing at least respective portions of the first to the third emission layers.

The first emission layer may include a first semiconductor layer that provides electrons, a second semiconductor layer that provides holes, and an active layer disposed between the first semiconductor layer and the second semiconductor layer. The first semiconductor layer may be electrically connected to any one of the a-th first electrode and the second electrode, and the second semiconductor layer may be electrically connected to a remaining one of the a-th first electrode and the second electrode.

The thickness of the first semiconductor layer may be greater than the thickness of the second semiconductor layer. The first semiconductor layer may be electrically connected to the second electrode, and the second semiconductor layer may be electrically connected to the a-th first electrode.

The display panel may further include a passivation layer disposed on the substrate, and covering side surfaces of the a-th to the c-th first electrodes, a first insulating layer disposed on the passivation layer, a first transmissive conductive layer disposed between the passivation layer and the first emission layer, and electrically connected to the a-th first electrode in an area formed by removing at least a portion of the passivation layer. The display panel may further include a second insulating layer disposed on the second emission layer, a second transmissive conductive layer disposed between the second insulating layer and the second emission layer, and electrically connected to the b-th first electrode in an area formed by removing at least a portion of the passivation layer, a third insulating layer disposed on the second emission layer, and a third transmissive conductive layer disposed between the third insulating layer and the third emission layer, and electrically connected to the c-th first electrode in an area formed by removing at least a portion of the passivation layer.

The display panel may further include a light blocking layer disposed in via holes enclosed by the passivation layer. The via holes may include a first via hole disposed in an area formed by removing at least respective portions of the first insulating layer, the first transmissive conductive layer, the first emission layer, the second insulating layer, the second transmissive conductive layer, the second emission layer, the third insulating layer, the third transmissive conductive layer, and the third emission layer, a second via hole disposed in an area formed by removing at least respective portions of the first insulating layer, the first transmissive conductive layer, the first emission layer, the second insulating layer, the second transmissive conductive layer, and the second emission layer, and a third via hole disposed in an area formed by removing at least respective portions of the first insulating layer, the first transmissive conductive layer, the first emission layer.

The light blocking layer may be formed through at least one of an electroplating process and a deposition process.

The light blocking layer may be planarized on the passivation layer.

The first wavelength band may correspond to a red wavelength band, the second wavelength band may correspond to a green wavelength band, and the third wavelength band may correspond to a blue wavelength band.

Each of the first to the third insulating layers may include an inorganic insulating layer.

An embodiment of the disclosure may provide a method of fabricating a display panel. The method may include forming a third emission layer, a third transmissive conductive layer, a third insulating layer, a second emission layer, a second transmissive conductive layer, a second insulating layer, a first emission layer, a first transmissive conductive layer, and a first insulating layer on a temporary substrate. The method may further include forming a first via hole, a second via hole, and a third via hole in the first insulating layer, the first via hole exposing at least a portion of the third emission layer, the second via hole exposing at least a portion of the second emission layer, and the third via hole exposing at least a portion of the first emission layer. The method may further include forming a first passivation layer enclosing the first to the third via holes, and forming a first contact hole, a second contact hole, and a third contact hole in the first passivation layer, the first contact hole exposing at least a portion of the third transmissive conductive layer, the second contact hole exposing at least a portion of the second transmissive conductive layer, and the third contact hole exposing at least a portion of the first transmissive conductive layer. The method may further include forming a second passivation layer enclosing the first to the third contact holes, removing the second passivation layer from areas corresponding to the first to the third contact holes, and forming a fourth contact hole in the second passivation layer. The method may further include forming a c-th first electrode in the first contact hole, forming a b-th first electrode in the second contact hole, forming an a-th first electrode in the first contact hole, and forming a second electrode in the second contact hole, electrically connecting the a-th to c-th first electrodes and the second electrode to a pixel circuit of the substrate, and removing the temporary substrate.

The forming of the first to the third via holes in the first insulating layer may include forming a first photoresist layer including a first pattern on the first insulating layer, forming a first via hole exposing at least a portion of the third emission layer in an area corresponding to the first pattern, and forming a second photoresist layer including a second pattern on the first insulating layer. The forming of the first to the third via holes in the first insulating layer may further include forming a second via hole exposing at least a portion of the second emission layer in an area corresponding to the second pattern, forming a third photoresist layer including a third pattern on the first insulating layer, and forming a third via hole exposing at least a portion of the first emission layer in an area corresponding to the third pattern.

The forming of the first to the third contact holes in the first passivation layer may include forming a fourth photoresist layer including a fourth pattern on the first passivation layer, forming a first contact hole exposing at least a portion of the third transmissive conductive layer in an area corresponding to the fourth pattern, and forming a fifth photoresist layer including a fifth pattern on the first passivation layer. The forming of the first to the third contact holes in the first passivation layer may further include forming a second contact hole exposing at least a portion of the second transmissive conductive layer in an area corresponding to the fifth pattern, forming a sixth photoresist layer including a sixth pattern on the first passivation layer, and forming a third contact hole exposing at least a portion of the first transmissive conductive layer in an area corresponding to the sixth pattern.

The removing of the second passivation layer from areas corresponding to the first to the third contact holes may include forming a seventh photoresist layer including a seventh pattern on the second passivation layer, the seventh pattern being formed by removing at least a portion of the seventh photoresist layer in areas corresponding to the first to the third contact holes, and removing the second passivation layer from an area corresponding to the seventh pattern.

The forming of the fourth contact hole in the second passivation layer may include forming an eighth photoresist layer including an eighth pattern on the second passivation layer, and forming a fourth contact hole in an area corresponding to the eighth pattern.

The method may further include forming a light blocking layer in areas corresponding to the first to the third via holes in an area enclosed by the first passivation layer.

The light blocking layer may be formed through a damascene process.

The light blocking layer may be formed by at least one of a chemical vapor deposition method, a physical vapor deposition method, and an atomic layer deposition method.

The first passivation layer and the second passivation layer may form a single passivation layer.

The temporary substrate may be a third temporary substrate. The forming of the third emission layer, the third transmissive conductive layer, the third insulating layer, the second emission layer, the second transmissive conductive layer, the second insulating layer, the first emission layer, the first transmissive conductive layer, and the first insulating layer on the temporary substrate may include growing the first emission layer on a first temporary substrate, growing the second emission layer on a second temporary substrate, growing the third emission layer on the third temporary substrate, and forming a first intermediate insulating layer on the first emission layer. The forming of the third emission layer, the third transmissive conductive layer, the third insulating layer, the second emission layer, the second transmissive conductive layer, the second insulating layer, the first emission layer, the first transmissive conductive layer, and the first insulating layer on the temporary substrate may further include forming a second intermediate insulating layer on the second emission layer, forming a third intermediate insulating layer on the third emission layer, forming a fourth intermediate insulating layer on a fourth temporary substrate, and forming a fifth intermediate insulating layer on a fifth temporary substrate. The forming of the third emission layer, the third transmissive conductive layer, the third insulating layer, the second emission layer, the second transmissive conductive layer, the second insulating layer, the first emission layer, the first transmissive conductive layer, and the first insulating layer on the temporary substrate may further include forming the first insulating layer by bonding the first intermediate insulating layer and the fourth intermediate insulating layer to each other, forming a sixth intermediate insulating layer by bonding the second intermediate insulating layer and the fifth intermediate insulating layer to each other, removing the first temporary substrate, and removing the second temporary substrate. The forming of the third emission layer, the third transmissive conductive layer, the third insulating layer, the second emission layer, the second transmissive conductive layer, the second insulating layer, the first emission layer, the first transmissive conductive layer, and the first insulating layer on the temporary substrate may further include forming a seventh intermediate insulating layer on the first emission layer, forming an eighth intermediate insulating layer on the second emission layer, forming the third insulating layer by bonding the third intermediate insulating layer and the eighth intermediate insulating layer to each other, removing the fifth temporary substrate, forming the first insulating layer by bonding the sixth intermediate insulating layer and the seventh intermediate insulating layer to each other, and removing the fourth temporary substrate.

An embodiment of the disclosure may provide smart glasses including a lens component that displays an image, and a frame that supports the lens component. The lens component may include a substrate on which a first pixel that emits light in a first wavelength band, a second pixel that emits light in a second wavelength band, and a third pixel that emits light in a third wavelength band are disposed, each of the first to third pixels including a pixel circuit. The lens component may further include a first emission layer disposed on the substrate, and that emits light in the first wavelength band, a second emission layer disposed on the first emission layer, and that emits light in the second wavelength band, and a third emission layer disposed on the second emission layer, and that emits light in the third wavelength band. The lens component may further include an a-th first electrode connected to the pixel circuit of the first pixel, and electrically connected to the first emission layer in a first contact hole, a b-th first electrode connected to the pixel circuit of the second pixel, and electrically connected to the second emission layer in a second contact hole formed by removing at least a portion of the first emission layer, a c-th first electrode connected to the pixel circuit of the third pixel, and electrically connected to the third emission layer in a third contact hole formed by removing at least respective portions of the first and the second emission layers, and a second electrode connected to the pixel circuit of each of the first to the third pixels, and connected to the first to the third emission layers in a fourth contact hole formed by removing at least respective portions of the first to the third emission layers.

### Advantageous Effects

According to a display panel, smart glasses including the display panel, and a method of fabricating the display panel in accordance with embodiments of the disclosure, a high-resolution image may be displayed.

According to a display panel, smart glasses including the display panel, and a method of fabricating the display panel in accordance with embodiments of the disclosure, a display panel having a thin structure may be fabricated.

### Description of Drawings

FIG. 1 is a schematic plan view illustrating a display panel in accordance with embodiments of the disclosure.
FIG. 2 is a schematic diagram of an equivalent circuit of a pixel in accordance with embodiments of the disclosure.
FIG. 3 is a schematic cross-sectional view of a display device in accordance with embodiments of the disclosure.
FIGS. 4A to 39 are schematic diagrams illustrating a method of fabricating a display panel in accordance with embodiments of the disclosure.
FIG. 40 is a schematic diagram illustrating a display panel fabricated according to FIGS. 4A to 39.
FIGS. 41 to 44 schematically illustrate examples of an electronic device in accordance with embodiments of the disclosure.

### Modes of the Invention

Hereinafter, embodiments of the disclosure will be described in detail with reference to the attached drawings, such that those skilled in the art can easily implement the disclosure. The disclosure may be implemented in various forms, and is not limited to the embodiments to be described herein below.

In the drawings, portions which are not related to the disclosure will be omitted in order to explain the disclosure more clearly. Reference should be made to the drawings, in which similar reference numerals are used throughout the different drawings to designate similar components. Therefore, the aforementioned reference numerals may be used in other drawings.

For reference, the size of each component and the thicknesses of lines illustrating the component may be arbitrarily represented for the sake of explanation, and the disclosure is not necessarily limited to what is illustrated in the drawings.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value.

Furthermore, the expression "being the same" may mean "being substantially the same". In other words, the expression "being the same" may include a range that can be tolerated by those skilled in the art.

It will be understood that, although the terms "a-th", "b-th", "c-th", "first", "second", etc. may be used herein to describe various elements, these elements should not be limited by these terms. These terms are only used to distinguish one element from another element. For instance, a first element discussed below could be termed a second element without departing from the teachings of the disclosure. Similarly, the second element could also be termed the first element. In the disclosure, the singular forms are intended to include the plural forms as well, unless the context clearly indicates otherwise.

The terms "under", "below", "above", "upper", and the like are used herein for explaining a relationship between one or more components illustrated in the drawings. These terms may be relative terms describing the positions of components in the drawings, but the positions of components are not limited thereto.

It will be further understood that the terms "comprise", "include", "have", etc. when used in this specification, specify the presence of stated features, integers, steps, operations, elements, components, and/or combinations of them but do not preclude the presence or addition of one or more other features, integers, steps, operations, elements, components, and/or combinations thereof.

In the specification and the claims, the term "and/or" is intended to include any combination of the terms "and" and "or" for the purpose of its meaning and interpretation. For example, "A and/or B" may be understood to mean "A, B, or A and B." The terms "and" and "or" may be used in the conjunctive or disjunctive sense and may be understood to be equivalent to "and/or."

In the specification and the claims, the phrase "at least one of" is intended to include the meaning of "at least one selected from the group of" for the purpose of its meaning and interpretation. For example, "at least one of A and B" may be understood to mean "A, B, or A and B."

Unless otherwise defined, all terms (including technical and scientific terms) used herein have the same meaning as commonly understood by one of ordinary skill in the art to which the disclosure pertains. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

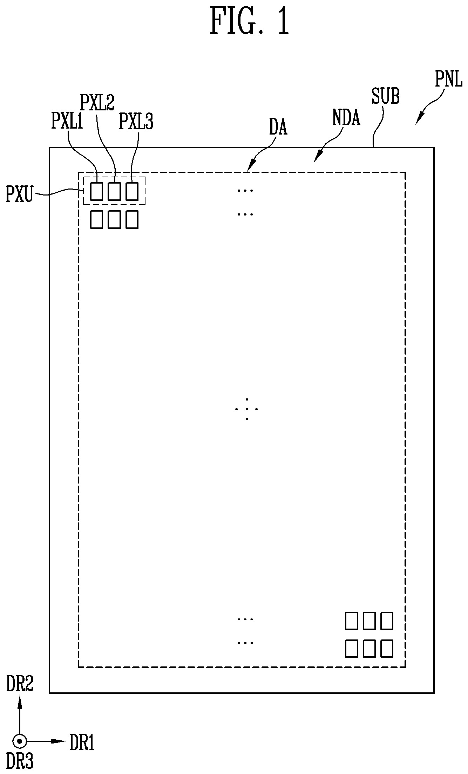

FIG. 1 is a schematic plan view illustrating a display panel PNL in accordance with embodiments of the disclosure.

FIG. 1 illustrates a display device where a light emitting element is used as a light source, particularly showing the display panel PNL provided in the display device.

For the sake of explanation, FIG. 1 simply illustrates the structure of the display panel PNL in accordance with an embodiment, focused on a display area DA. In some embodiments, although not illustrated, at least one driving circuit (e.g., at least one of a scan driver and a data driver), lines, and/or pads may be further provided on the display panel PNL.

Referring to FIG. 1, the display panel PNL may include a substrate SUB, and a unit pixel PXU disposed on the substrate SUB. The unit pixel PXU may include multiple pixels PXL. For example, the unit pixel PXU may include a first pixel PXL1, a second pixel PXL2, and a third pixel PXL3. Hereinafter, the term "pixel PXL" or "pixels PXL" will be used to arbitrarily designate at least one pixel of the first pixel PXL1, the second pixel PXL2, and the third pixel PXL3, or collectively designate two or more kinds of pixels.

The substrate SUB may form a base of the display panel PNL and be a rigid or flexible substrate or film. For example, the substrate SUB may be a rigid substrate made of glass or reinforced glass, a flexible substrate (or a thin film) formed of plastic or metal, and the material and/or properties of the substrate SUB are not particularly limited. For example, the substrate SUB may be formed of a silicon substrate.

The display panel PNL and the substrate SUB for forming the display panel PNL may include a display area DA for displaying an image, and a non-display area NDA other than the display area DA. The pixel PXL may be disposed in the display area DA. Various lines, pads, and/or internal circuits which are connected to the pixels PXL of the display area DA may be disposed in the non-display area NDA. The pixels PXL may be regularly arranged according to a stripe or PENTILE^{™} arrangement structure. The arrangement structure of the pixels PXL is not limited thereto, and the pixels PXL may be arranged in the display area DA in various structures and/or schemes.

In an embodiment, two or more kinds of pixels PXL which emit different colors of light may be disposed in the display area DA. For example, in the display area DA, there may be arranged a first pixel PXL1 configured to emit light in a first wavelength band (or first color), a second pixel PXL2 configured to emit light in a second wavelength band (or second color), a third pixel PXL3 configured to emit light in a third wavelength band (or third color). At least one first pixel PXL1, at least one second pixel PXL2, and at least one third pixel PXL3 that are disposed adjacent to each other may form one unit pixel PXU, which may emit various colors of light. For example, each of the first to third pixels PXL1, PXL2, and PXL3 may be a sub-pixel configured to emit a certain color of light. In an embodiment, the first pixel PXL1 may be a red pixel configured to emit light in the red wavelength band, the second pixel PXL2 may be a green pixel configured to emit light in the green wavelength band, and the third pixel PXL3 may be a blue pixel configured to emit light in the blue wavelength band, but embodiments are not limited thereto. For example, the red wavelength band may range from approximately 630 nm to approximately 750 nm (nanometers). For example, the green wavelength band may range from approximately 495 nm to approximately 570 nm. For example, the blue wavelength band may range from approximately 450 nm to approximately 495 nm.

In an embodiment, the first pixel PXL1, the second pixel PXL2, and the third pixel PXL3 may respectively include light emitting elements configured to emit the same color of light, and color conversion layers and/or color filters pertaining to different colors may be disposed on the respective light emitting elements so that the first pixel PXL1, the second pixel PXL2, and the third pixel PXL3 may respectively emit the first color of light, the second color of light, and the third color of light. In an embodiment, the first pixel PXL1, the second pixel PXL2, and the third pixel PXL3 may respectively include, as light sources, a light emitting element related to the first color, a light emitting element related to the second color, and a light emitting element related to the third color, and thus may respectively emit the first color of light, the second color of light, and the third color of light. However, the color, type, and/or number of pixels PXL that form each unit pixel PXU is not particularly limited. In other words, the color of light to be emitted from each pixel PXL may be changed in various ways.

The pixel PXL may include at least one light source which is driven by a control signal (e.g., a scan signal and a data signal) and/or a power supply (e.g., a first power voltage and a second power voltage).

In an embodiment, each pixel PXL may be configured as an active pixel. However, the type, structure, and/or driving schemes of the pixels PXL applicable to the display device are not particularly limited. For example, each pixel PXL may be configured as a pixel for passive or active light emitting display devices which have various structures and/or may be operated in various driving schemes.

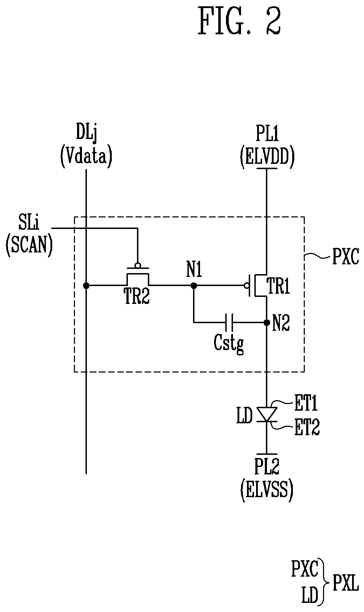

FIG. 2 is a schematic diagram of an equivalent circuit of the pixel PXL in accordance with embodiments of the disclosure.

FIG. 2 illustrates an electrical connection relationship of components included in the pixel PXL that may be employed in an active display device. Here, the type of components included in the pixel PXL is not necessarily limited to the aforementioned example.

In an embodiment, the pixel PXL illustrated in FIG. 2 may be any of the first pixel PXL1, the second pixel PXL2, and the third pixel PXL3 which may be provided on the display panel PNL of FIG. 1. The first pixel PXL1, the second pixel PXL2, and the third pixel PXL3 may have substantially identical or similar structures.

Referring to FIG. 2, the pixel PXL may include a light emitting element LD configured to generate light having a luminance corresponding to each data signal. The pixel PXL may include a pixel circuit PXC configured to drive the light emitting element LD.

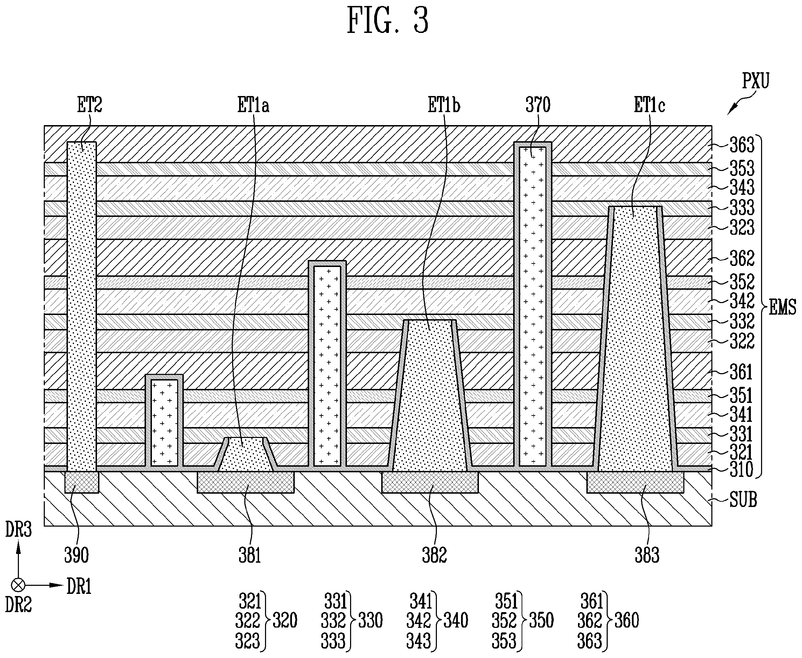

In an embodiment, the pixel PXL may include at least one light emitting element LD that is electrically connected between a first power supply line PL1 to which a first driving power voltage ELVDD is applied and a second power supply line PL2 to which a second driving power voltage ELVSS is applied. For example, the light emitting element LD may include a first electrode ET1 connected (e.g., electrically connected) to the pixel circuit PXC and the first power line PL1, and a second electrode ET2 connected (e.g., electrically connected) to the second power line PL2. In an embodiment, the first electrode ET1 may be an anode electrode, and the second electrode ET2 may be a cathode electrode. The light emitting element LD may further include an emission structure configured to be supplied with a voltage through the first electrode ET1 and the second electrode ET2 and emit light using the supplied voltage. The emission structure will be described later herein with reference to FIG. 3 and the following drawings.

The first power voltage ELVDD and the second power voltage ELVSS may have different potentials. Here, a difference in potential between the first and second power voltages ELVDD and ELVSS may be set to a value equal to or greater than a threshold voltage of the light emitting element LD during an emission period of the pixel PXL.

The light emitting element LD may function as a light source of the pixel PXL. The light emitting element LD may emit light having a luminance corresponding to driving current supplied thereto through the pixel circuit PXC. For example, during each frame period, the pixel circuit PXC may supply driving current corresponding to a grayscale value of corresponding frame data. As a result, the light emitting element LD may emit light with a luminance corresponding to the driving current, whereby the emission structure can emit light.

The pixel circuit PXC may be connected (e.g., electrically connected) to a scan line SLi and a data line DLj of the pixel PXL. For example, in the case where the pixel PXL is disposed on an i-th row (i is an integer of 1 or more) and a j-th column (j is an integer of 1 or more) of the display area DA (refer to FIG. 1), the pixel circuit PXC of the pixel PXL may be connected to an i-th scan line SLi and a j-th data line DLj of the display area DA. In an embodiment, the pixel circuit PXC may include first and second transistors TR1 and TR2, and a storage capacitor Cstg. However, the structure of the pixel circuit PXC in accordance with embodiments of the disclosure is not limited to the embodiment illustrated in FIG. 2.

The first transistor TR1 may include a gate electrode connected (e.g., electrically connected) to a first node N1. The first transistor TR1 may include a first electrode connected (e.g., electrically connected) to a second node N2. The first transistor TR1 may include a second electrode connected (e.g., electrically connected) to the first power line PL1. The first electrode may be either a source electrode or a drain electrode (e.g., be the drain electrode). The second electrode may be a remaining one of the source electrode and the drain electrode (e.g., be the source electrode). Current (e.g., driving current) corresponding to a voltage applied to the first node N1 may flow to the first transistor TR1. The first transistor TR1 may be referred to as a driving transistor.

The second transistor TR2 may be configured to write a data voltage Vdata to the pixel circuit PXC. The second transistor TR2 may include a gate electrode connected (e.g., electrically connected) to the i-th scan line SLi. The second transistor TR2 may be configured to input the data voltage Vdata to the pixel circuit PXC, in response to a scan signal SCAN (e.g., a scan signal SCAN with a turn-on level) inputted to the i-th scan line SLi. Referring to FIG. 2, the second transistor TR2 may be configured to switch electrical connection between the j-th data line DLj and the first node N1. The second transistor TR2 may be referred to as a switching transistor.

The storage capacitor Cstg may include a first side electrode connected (e.g., electrically connected) to the first node N1, and a second side electrode connected (e.g., electrically connected) to the second node N2. The storage capacitor Cstg may be configured to maintain a difference in voltage between the first node N1 and the second node N2. For example, the storage capacitor Cstg may be configured to maintain the data voltage Vdata applied to the first node N1 during a certain period (e.g., one frame period).

In FIG. 2, there is illustrated the pixel circuit PXC including the second transistor TR2 configured to write the data voltage Vdata to the pixel PXL, the storage capacitor Cstg configured to store the data voltage Vdata, and the first transistor TR1 configured to supply driving current corresponding to the data voltage Vdata to the light emitting element LD. However, embodiments of the disclosure are not limited to the aforementioned example, and the structure of the pixel circuit PXC may be changed in various ways. For example, the pixel circuit PXC may further include a transistor element configured to compensate for variation in threshold voltage of the first transistor TR1, a transistor element configured to initialize the voltage of the first node N1, and/or a transistor element configured to control a length of time for which the light emitting element LD (or light emitting elements) emits light. In an embodiment, the pixel circuit PXC may further include circuit elements such as a boosting capacitor configured to boost the voltage of the first node N1.

Referring to FIG. 2, there is illustrated the pixel circuit PXC in accordance with embodiments of the disclosure where each of the first and second transistors TR1 and TR2 is implemented using a transistor including a p-type semiconductor layer {e.g., a P-channel metal oxide semiconductor (PMOS)}. However, embodiments of the disclosure are not limited to the aforementioned example, and at least one of the first and second transistors TR1 and TR2 may be implemented using a transistor including an n-type semiconductor layer {e.g., an N-channel metal oxide semiconductor (NMOS)}. The p-type semiconductor layer may include, for example, a metal oxide semiconductor. The n-type semiconductor layer may include, for example, a polycrystalline silicon semiconductor.

FIG. 3 is a schematic cross-sectional view of a display device in accordance with embodiments of the disclosure.

FIG. 3 illustrates a sectional view of the unit pixel PXU in the display panel and, more particularly, illustrates the emission structure EMS, the first electrode ET1, and the second electrode ET2 in the unit pixel PXU.

In accordance with embodiments of the disclosure, the unit pixel PXU (or pixels) may be disposed in the display panel. The display panel in accordance with embodiments of the disclosure may include the substrate SUB, and the emission structure EMS, the first electrode ET1, and the second electrode ET2 that are disposed on the substrate SUB. The display panel may further include a light blocking layer 370 configured to prevent light emitted from the respective pixels from being mixed with each other.

The substrate SUB may be configured of a silicon (Si) substrate, a silicon carbide (SiC) substrate, or the like. However, embodiments of the disclosure are not limited to the foregoing example.

A pixel circuit of each of the pixels included in the unit pixel PXU may be disposed on the substrate SUB. Referring to FIG. 3, it is illustrated that a pixel circuit 381 of the first pixel PXL1 (refer to FIG. 1), a pixel circuit 382 of the second pixel PXL2 (refer to FIG. 1), and a pixel circuit 383 of the third pixel PXL3 (refer to FIG. 1) are disposed on the substrate SUB.

The second power line PL2 (refer to FIG. 2) may be disposed on the substrate SUB. Referring to FIG. 3, there is illustrated a second power line 390, corresponding to the second power line PL2 in an equivalent circuit diagram of FIG. 2.

The first electrode ET1 may include an a-th first electrode ET1a, a b-th first electrode ET1b, and a c-th first electrode ET1c. The a-th first electrode ET1a may be connected to the pixel circuit 381 of the first pixel. The b-th first electrode ET1b may be connected to the pixel circuit 382 of the second pixel. The c-th first electrode ET1c may be connected to the pixel circuit 383 of the third pixel.

The second electrode ET2 may be connected to the second power line 390. Consequently, the second electrode ET2 may function as a common electrode of the first to third pixels PXL1 to PXL3 (refer to FIG. 1).

The emission structure EMS may include a passivation layer 310, an insulating layer 320, a transmissive conductive layer 330, a first semiconductor layer 340, an active layer 350, a second semiconductor layer 360, etc. The first semiconductor layer 340, the active layer 350, and the second semiconductor 360 may form an emission layer.

The passivation layer 310 may be disposed on the substrate SUB (e.g., to cover the substrate SUB). The passivation layer 310 may be configured to electrically insulate between the emission structure EMS and metal {e.g., copper (Cu)} constituting the light blocking layer 370. The passivation layer 310 may include, for example, inorganic material such as silicon oxide (SiOₓ), silicon nitride (SiNₓ), silicon oxynitride (SiOₓN_{y}), silicon oxycarbide (SiOₓC_{y}), aluminium oxide (AlOₓ), aluminium nitride (AlNₓ), zirconium oxide (ZrOₓ), hafnium oxide (HfOₓ), or titanium oxide (TiOₓ). However, embodiments of the disclosure are not limited to the foregoing example.

The insulating layer 320 may be disposed on the passivation layer 310. The insulating layer 320 may function to prevent the transmissive conductive layer 331 from being directly connected to the substrate SUB. The insulating layer 320 may include inorganic materials such as silicon oxide (SiOₓ), silicon nitride (SiNₓ), silicon oxynitride (SiOₓN_{y}), silicon oxycarbide (SiOₓC_{y}), aluminium oxide (AlOₓ), aluminium nitride (AlNₓ), zirconium oxide (ZrOₓ), hafnium oxide (HfOₓ), or titanium oxide (TiOₓ). The insulating layer 320 may include a first insulating layer 321, a second insulating layer 322, and a third insulating layer 323.

The transmissive conductive layer 330 may be disposed on the insulating layer 320. The transmissive conductive layer 330 may include metal or metal oxide. For example, the transmissive conductive layer 330 may include at least one of various transparent conductive materials including indium tin oxide (ITO), indium zinc oxide (IZO), indium tin zinc oxide (ITZO), aluminium zinc oxide (AZO), gallium zinc oxide (GZO), zinc tin oxide (ZTO), or gallium tin oxide (GTO). The transmissive conductive layer 330 may be implemented to be substantially transparent or translucent to satisfy a certain level of light transmittance. Accordingly, light emitted from the emission structure EMS may be emitted out of the display panel PNL through the transmissive conductive layer 330. In an embodiment, the transmissive conductive layer 330 may include metal or metal oxide. For example, the transmissive conductive layer 330 may include materials such as copper (Cu), gold (Au), chromium (Cr), titanium (Ti), aluminium (Al), nickel (Ni), indium tin oxide (ITO), and oxides or alloys thereof, but embodiments of the disclosure are not limited thereto. The transmissive conductive layer 330 may include a first transmissive conductive layer 331, a second transmissive conductive layer 332, and a third transmissive conductive layer 333.

The first semiconductor layer 340 may be disposed on the transmissive conductive layer 330. The first semiconductor layer 340 may include either a p-type semiconductor layer or an n-type semiconductor layer. Hereinafter, for the sake of convenience in explanation, an embodiment where the first semiconductor layer 340 includes a p-type semiconductor layer will be described by way of example, but embodiments of the disclosure are not limited thereto. The first semiconductor layer 340 may include a p-type semiconductor layer that includes semiconductor material such as GaN, InGaN, InAlGaN, AlGaN, or AlN, and is doped with a first conductive dopant (or p-type dopant) such as magnesium (Mg), zinc (Zn), calcium (Ca), strontium (Sr), or barium (Ba). The first semiconductor layer 340 may include a 1-th first semiconductor layer 341, a 2-th first semiconductor layer 342, and a 3-th first semiconductor layer 343.

The active layer 350 may be disposed between the first semiconductor layer 340 and the second semiconductor layer 360. The active layer 350 may include any one structure of a single well structure, a multi-well structure, a single-quantum well structure, a multi-quantum well (MQW) structure, a quantum dot structure, and a quantum line structure, but embodiments of the disclosure are not limited thereto. The active layer 350 may include AlGaN, InGaN, or GaN. In addition, various other materials may be used to form the active layer 350. The active layer 350 may include a first active layer 351, a second active layer 352, and a third active layer 353.

The first active layer 351, the second active layer 352, and the third active layer 353 may be configured to emit light in different wavelength bands, respectively. For example, the first active layer 351 may be configured to emit light in a relatively long wavelength band. The third active layer 353 may be configured to emit light in a relatively short wavelength band. For example, the first active layer 351 may be configured to emit light in a red wavelength band. The second active layer 352 may be configured to emit light in a green wavelength band. The third active layer 353 may be configured to emit light in a blue wavelength band.

The second semiconductor layer 360 may be disposed on the active layer 350. The second semiconductor layer 360 may include a remaining one of the p-type semiconductor layer and the n-type semiconductor layer. Hereinafter, for the sake of convenience in explanation, an embodiment where the second semiconductor layer 360 includes an n-type semiconductor layer will be described by way of example, but embodiments of the disclosure are not limited thereto. The second semiconductor layer 360 may be an n-type semiconductor layer that includes semiconductor material such as GaN, InGaN, InAlGaN, AlGaN, or AlN, and is doped with a second conductive dopant (or an n-type dopant) such as germanium (Ge), selenium (Se), tellurium (Te), or tin (Sn). For example, the second semiconductor layer 360 of the light emitting element LD may include GaN semiconductor material doped with a second conductive dopant (or an n-type dopant). However, the material for forming the second semiconductor layer 360 is not limited thereto, and the second semiconductor layer 360 may be formed of various other materials.

The light blocking layer 370 may be configured to prevent color mixing. The light blocking layer 370 enclosed by the passivation layer 310 may function to electrically insulate the first electrode ET1 and the second electrode ET2 from each other. For example, light emitted from the first pixel PXL1 (refer to FIG. 1) may be emitted through an area on the a-th first electrode ET1a. Light emitted from the second pixel PXL2 (refer to FIG. 1) may be emitted through an area on the b-th first electrode ET1b. Light emitted from the third pixel PXL3 (refer to FIG. 1) may be emitted through an area on the c-th first electrode ET1c. The light blocking layer 370 may be disposed between the respective pixels (between the respective pixel circuits) to prevent light emitted from the respective pixels from being mixed with each other.

The first electrode ET1 may be connected to the transmissive conductive layer 330. The a-th first electrode ET1a may be connected to the first transmissive conductive layer 331. The b-th first electrode ET1b may be connected to the second transmissive conductive layer 332. The c-th first electrode ET1c may be connected to the third transmissive conductive layer 333. The first electrode ET1 may supply a positive voltage (or a voltage of relatively high potential) to the transmissive conductive layer 330.

The second electrode ET2 may be connected to the second semiconductor layer 360 (e.g., a side surface of the second semiconductor layer 360). The second electrode ET2 may supply a negative voltage (or a voltage of relatively low potential) to the second semiconductor layer 360. The thickness of the second semiconductor layer 360 may be greater than the thickness of the first semiconductor layer 340. Consequently, it may be relatively easy for the second electrode ET2 to supply a voltage to the second semiconductor layer 360.

The emission structure EMS on the substrate SUB may be disposed on a basis of the unit pixel PXU. However, embodiments of the disclosure are not limited to the aforementioned example. For example, the emission structures EMS of two or more unit pixels PXU may be integrally formed with each other and disposed on the substrate SUB.

Hereinafter, a method of fabricating the display panel including the emission structure EMS in accordance with embodiments of the disclosure will be described in more detail.

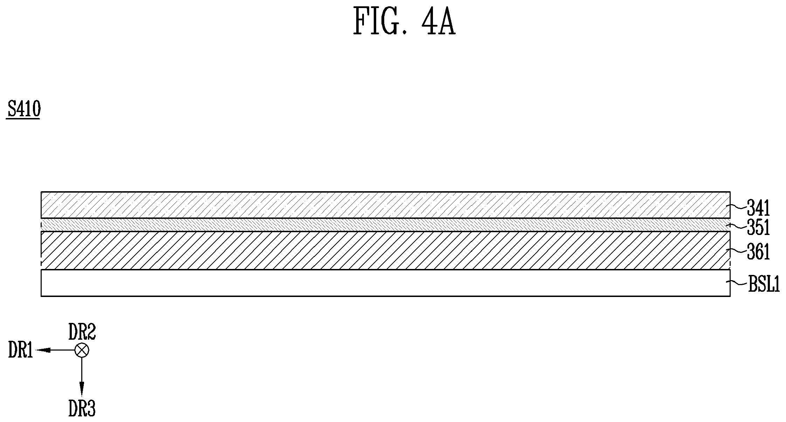

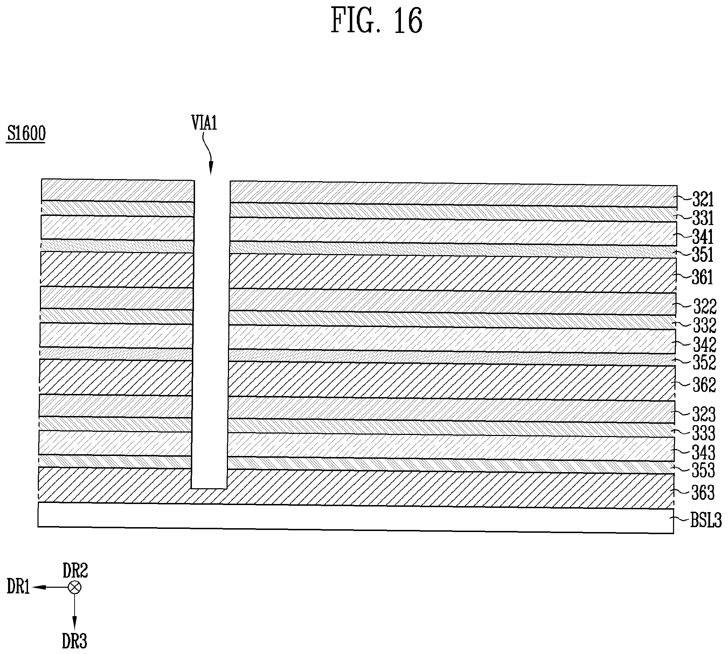

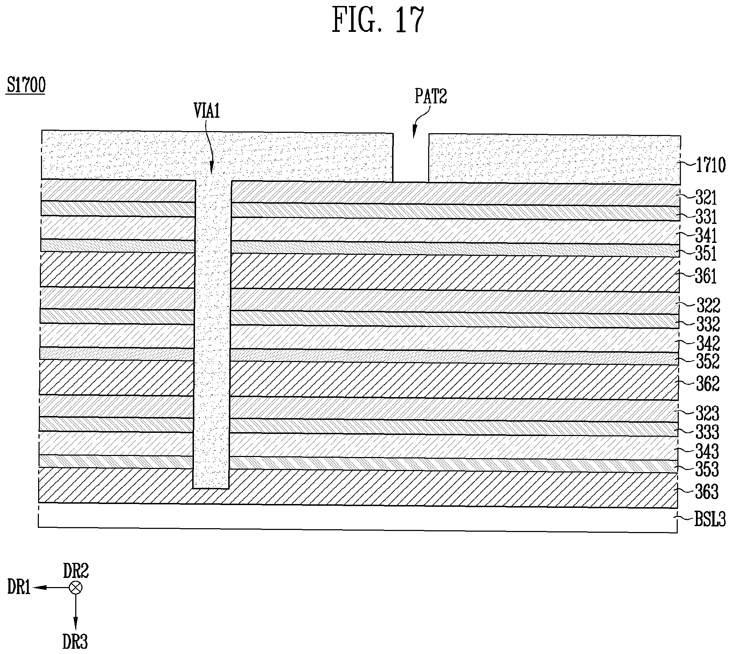

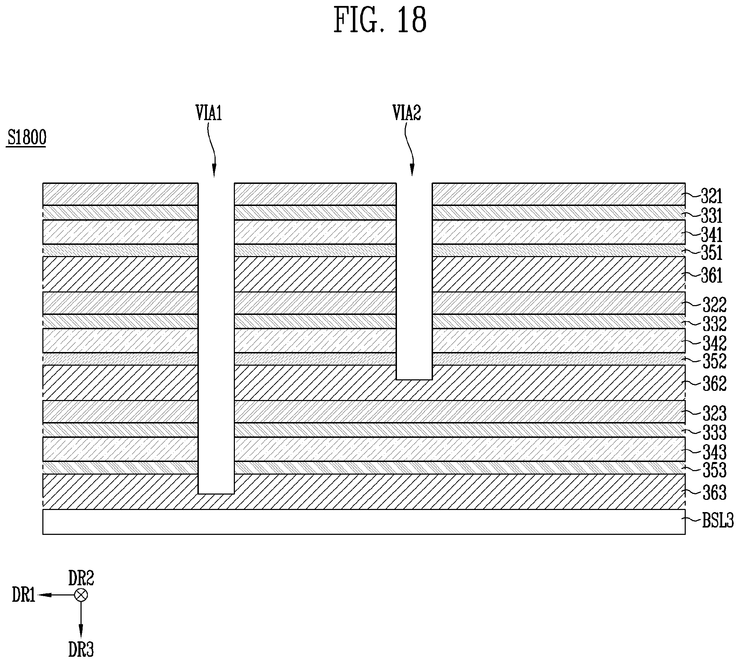

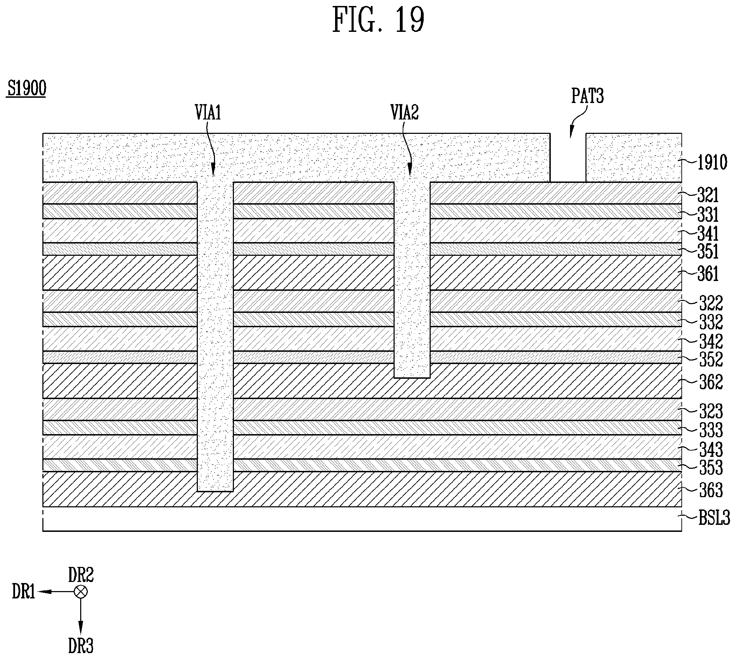

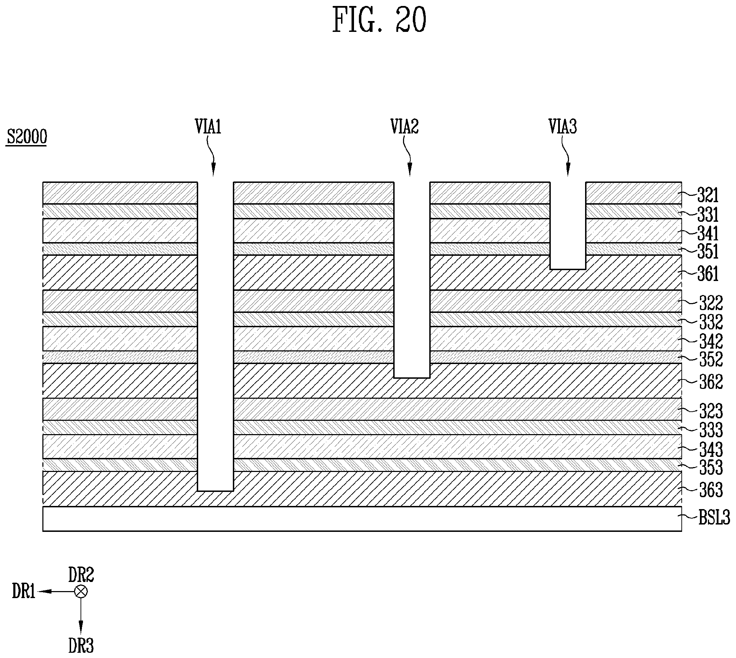

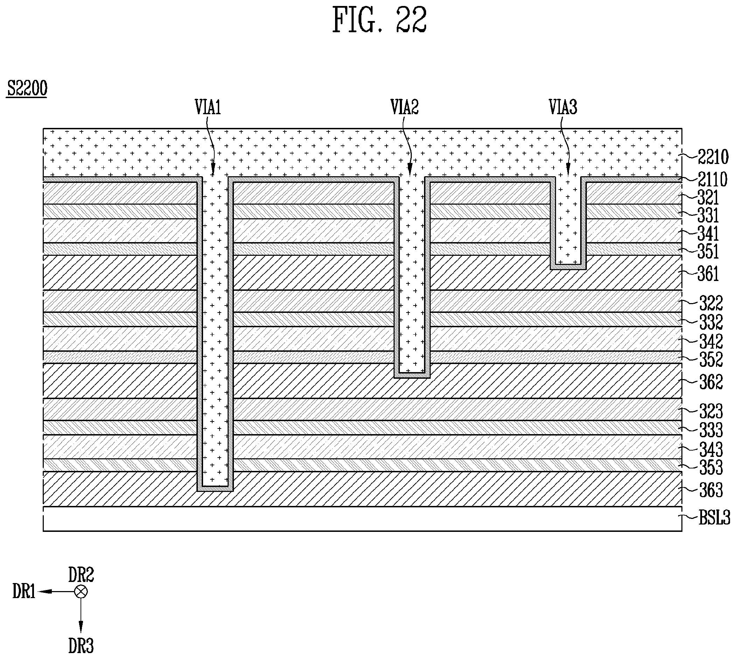

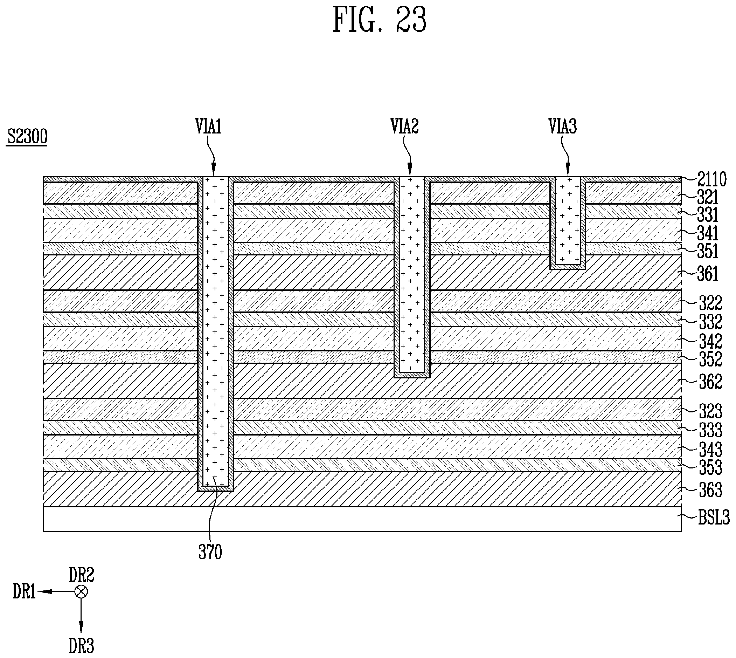

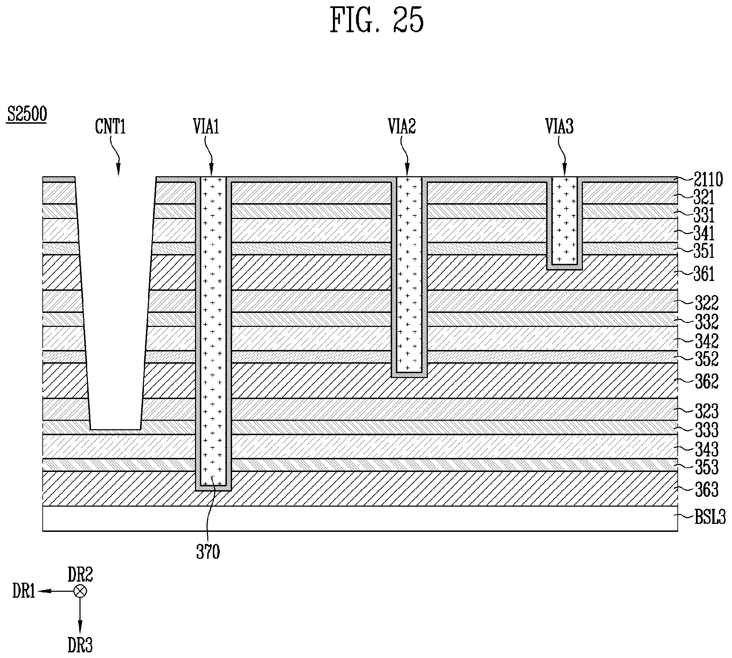

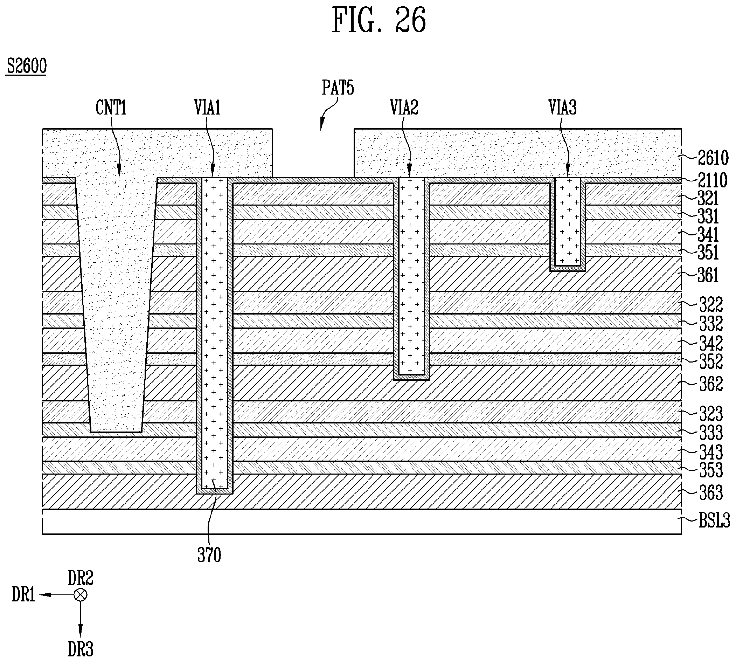

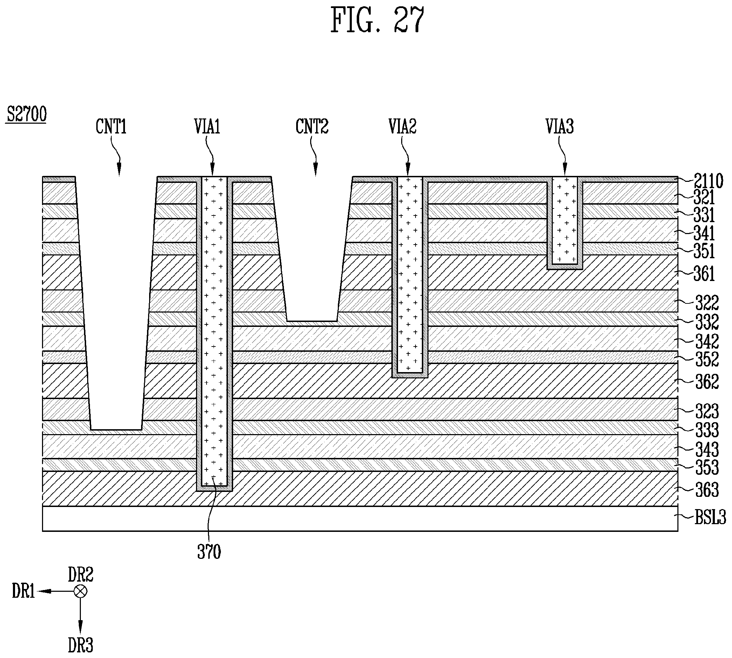

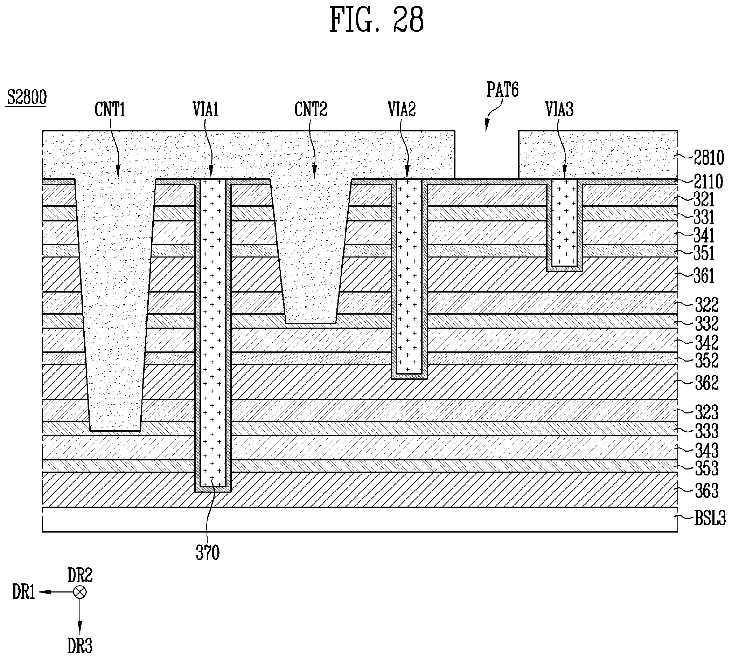

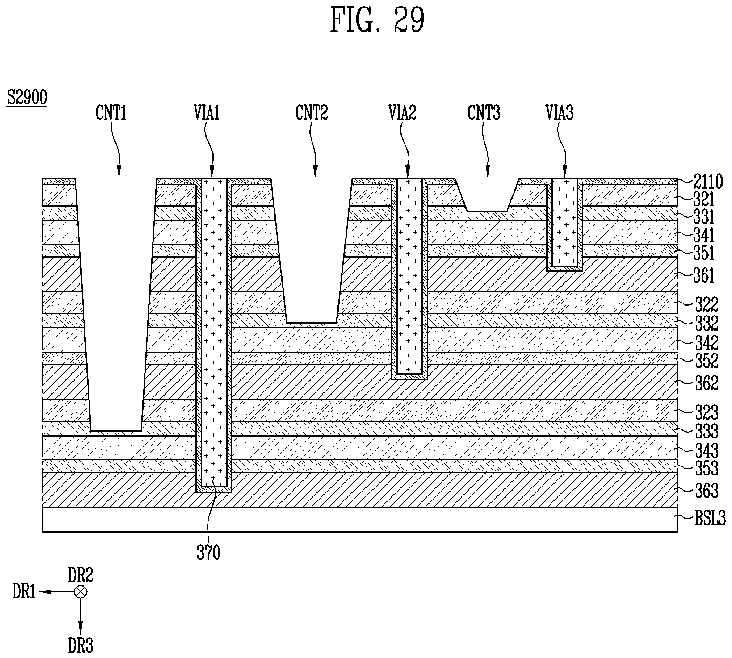

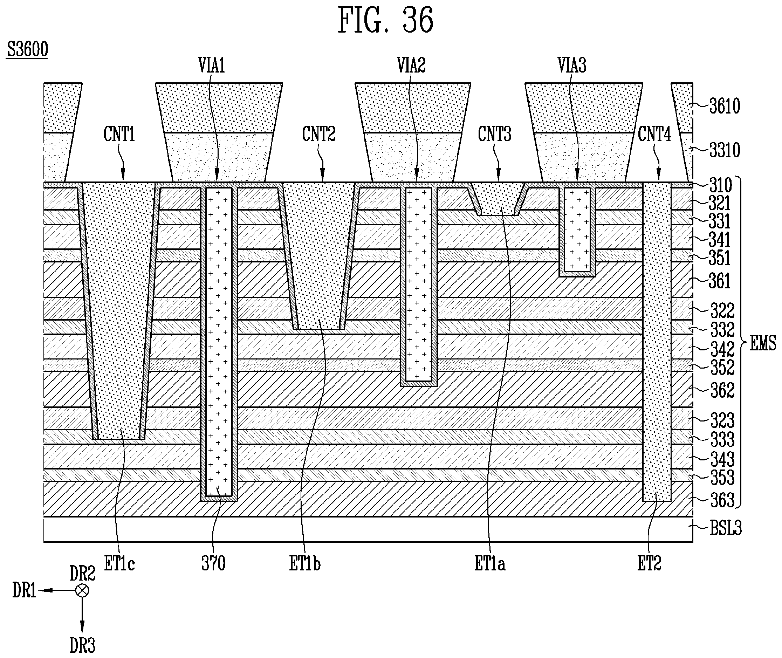

FIGS. 4A to 39 are schematic diagrams illustrating a method of fabricating the display panel in accordance with embodiments of the disclosure.

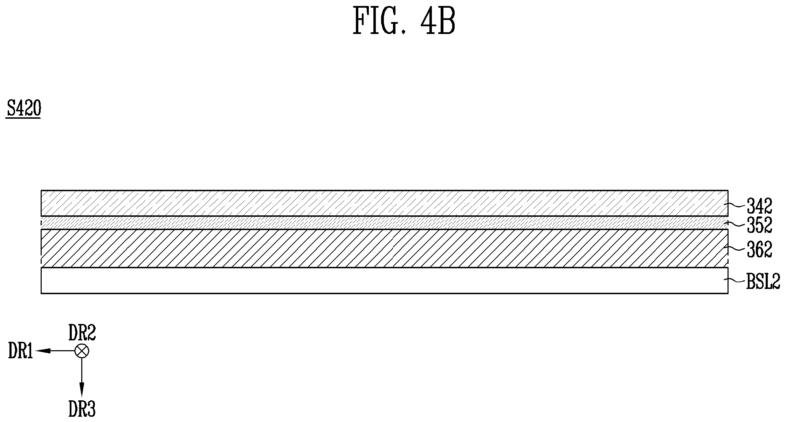

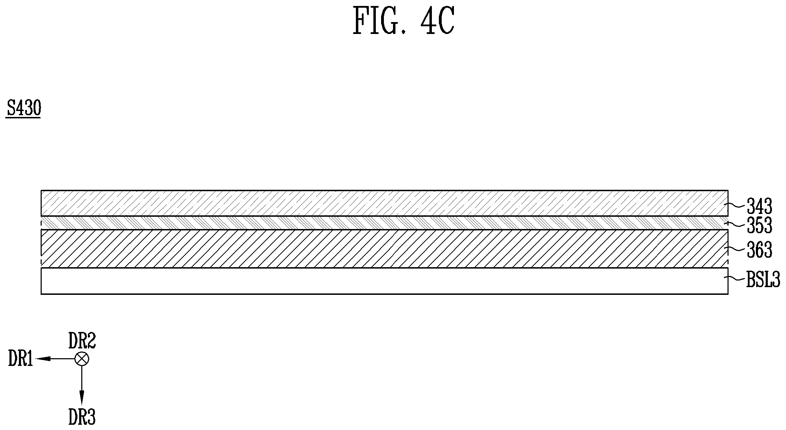

Referring to FIGS. 4A, 4B, and 4C, there is illustrated the step of growing an emission layer on a temporary substrate.

The method of fabricating the display panel in accordance with embodiments of the disclosure may include step S410 of forming a first emission layer on a first temporary substrate BSL1, step S420 of forming a second emission layer on a second temporary substrate BSL2, and step S430 of forming a third emission layer on a third temporary substrate BSL3.

At step S410 of forming the first emission layer, a 1-th second semiconductor layer 361, the first active layer 351, and the 1-th first semiconductor layer 341 may be sequentially formed on the first temporary substrate BSL1 (e.g., in a direction opposite to the third direction DR3 from the first temporary substrate BSL1).

At step S420 of forming the second emission layer, a 2-th second semiconductor layer 362, the second active layer 352, and the 2-th first semiconductor layer 342 may be sequentially formed on the second temporary substrate BSL2.

At step S430 of forming the third emission layer, a 3-th second semiconductor layer 363, the third active layer 353, and the 3-th first semiconductor layer 343 may be sequentially formed on the third temporary substrate BSL3.

Each of the first to third temporary substrates BSL1, BSL2, and BSL3 may be configured of a sapphire substrate, a silicon (Si) substrate, a silicon carbide (SiC) substrate, or the like. However, embodiments of the disclosure are not limited to the foregoing example. For example, each of the first to third temporary substrates BSL1, BSL2, and BSL3 may be formed using a single-crystal substrate having a lattice structure, or the like. Each of the first to third temporary substrates BSL1, BSL2, and BSL3 may further include a buffer layer formed on one surface thereof.

The first to third emission layers may each be formed by growing a seed crystal by an epitaxial method. In an embodiment, each of the first to third emission layers may be formed by a metal organic chemical vapor deposition (MOCVD) method. However, embodiments of the disclosure are not limited to the foregoing example. For example, each of the first to third emission layers may be formed by various methods, including electron beam deposition, physical vapor deposition (PVD), chemical vapor deposition (CVD), plasma laser deposition (PLD), dual-type thermal evaporation, or sputtering.

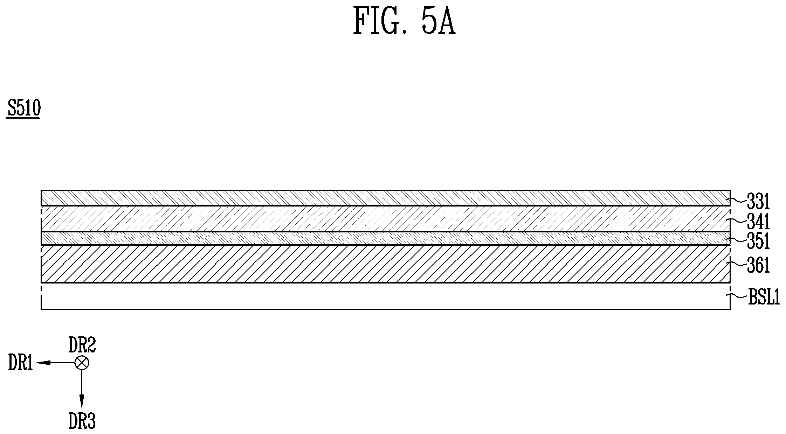

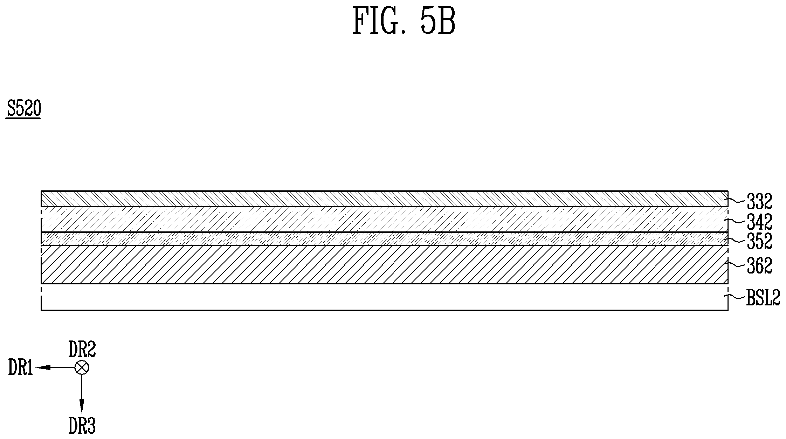

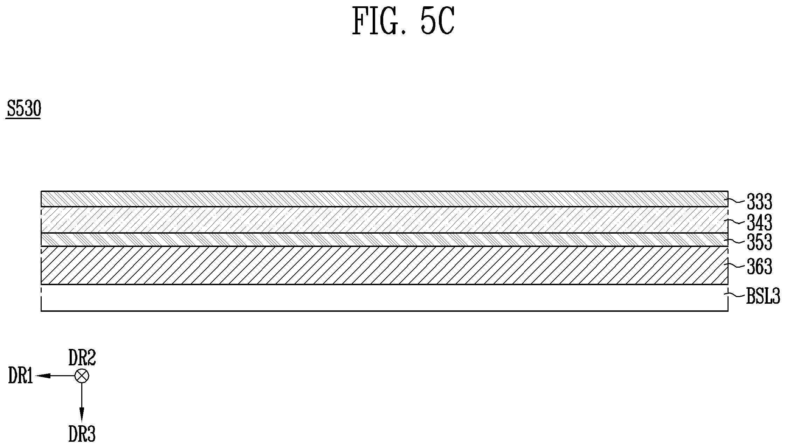

Referring to FIGS. 5A, 5B, and 5C, there is illustrated the step of forming a transmissive conductive layer on the emission layer.

The method of fabricating the display panel in accordance with embodiments of the disclosure may include step S510 of forming the first transmissive conductive layer 331 on the first emission layer, step S520 of forming the second transmissive conductive layer 332 on the second emission layer, and step S530 of forming the third transmissive conductive layer 333 on the third emission layer.

At step S510 of forming the first transmissive conductive layer 331 on the first emission layer, the first transmissive conductive layer 331 may be formed on the first emission layer. The first transmissive conductive layer 331 may be formed on the 1-th first semiconductor layer 341.

At step S520 of forming the second transmissive conductive layer 332 on the second emission layer, the second transmissive conductive layer 332 may be formed on the second emission layer. The second transmissive conductive layer 332 may be formed on the 2-th first semiconductor layer 342.

At step S530 of forming the third transmissive conductive layer 333 on the third emission layer, the third transmissive conductive layer 333 may be formed on the third emission layer. The third transmissive conductive layer 333 may be formed on the 3-th first semiconductor layer 343.

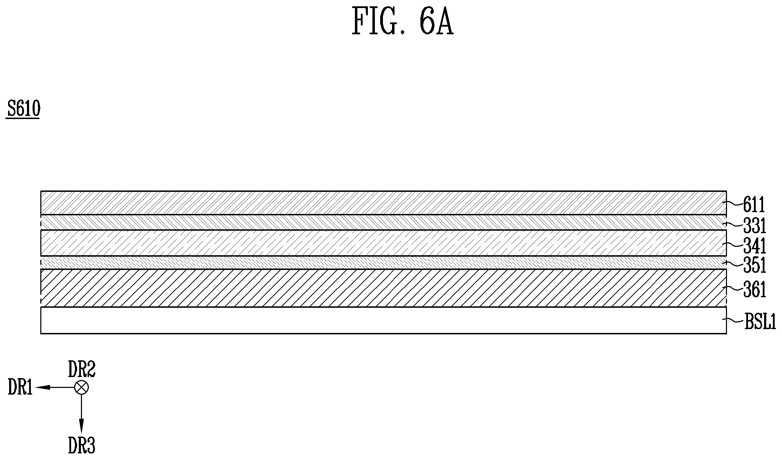

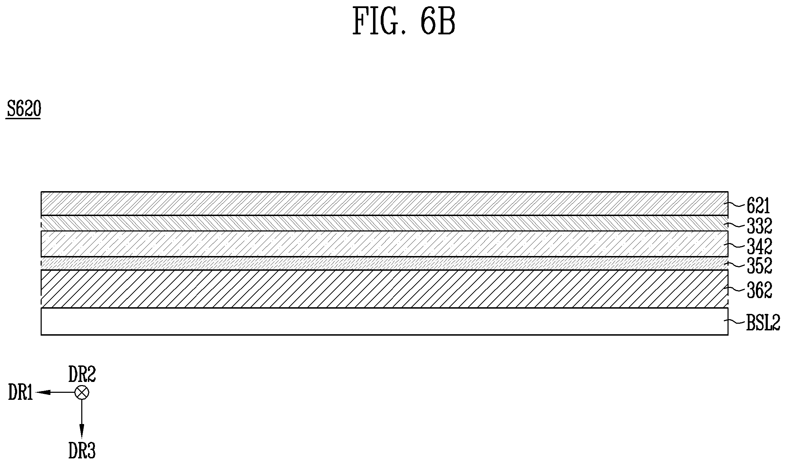

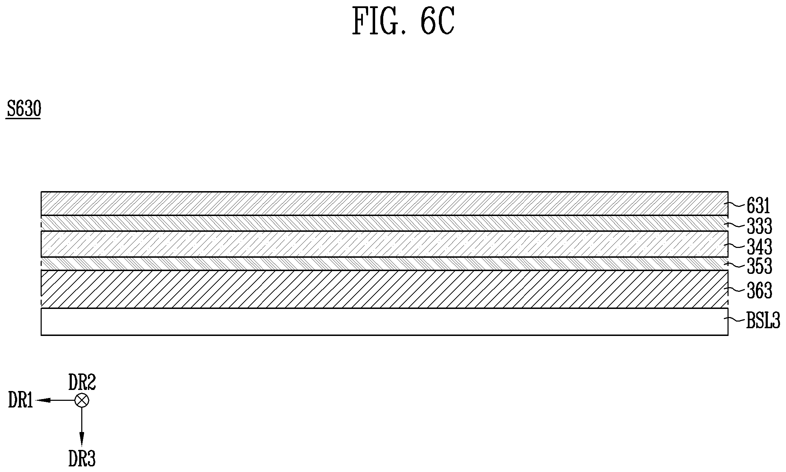

Referring to FIGS. 6A to 6C, there is illustrated the step of forming an insulating layer (for example, an intermediate insulating layer) on the emission layer.

The method of fabricating the display panel in accordance with embodiments of the disclosure may include step S610 of forming a first intermediate insulating layer 611 on the first transmissive conductive layer 331, step S620 of forming a second intermediate insulating layer 621 on the second transmissive conductive layer 332, and step S630 of forming a third intermediate insulating layer 631 on the third transmissive conductive layer 333.

Each of the first to third intermediate insulating layers 611, 621, and 631 may be configured of an inorganic insulating layer. For example, each of the first to third intermediate insulating layers 611, 621, and 631 may include inorganic material such as silicon oxide (SiOₓ), silicon nitride (SiNₓ), silicon oxynitride (SiOₓN_{y}), silicon oxycarbide (SiOₓC_{y}), aluminium oxide (AlOₓ), aluminium nitride (AlNₓ), zirconium oxide (ZrOₓ), hafnium oxide (HfOₓ), or titanium oxide (TiOₓ). However, embodiments of the disclosure are not limited to the foregoing example.

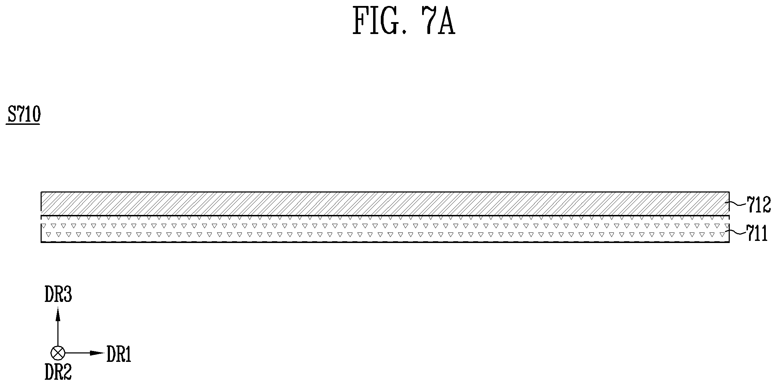

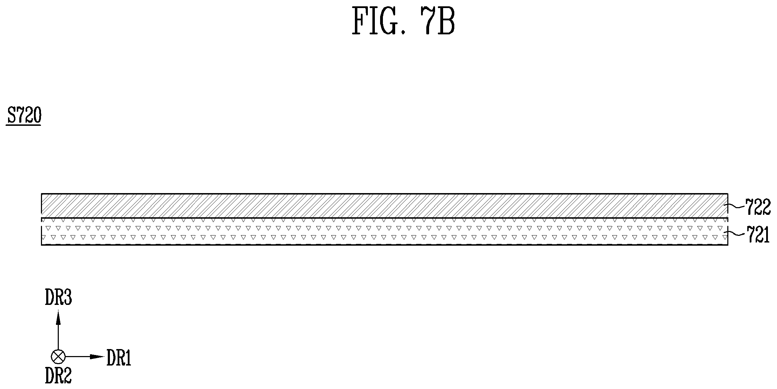

Referring to FIGS. 7A and 7B, there is illustrated the step of forming an insulating layer (for example, an intermediate insulating layer) on the temporary substrate.

The method of fabricating the display panel in accordance with embodiments of the disclosure may include step S710 of forming a fourth intermediate insulating layer 712 on a fourth temporary substrate 711, and step S720 of forming a fifth intermediate insulating layer 722 on a fifth temporary substrate 721.

At step S710 of forming the fourth intermediate insulating layer 712 on the fourth temporary substrate 711, the fourth intermediate insulating layer 712 may be formed in the third direction DR3 from the fourth temporary substrate 711.

At step S720 of forming the fifth intermediate insulating layer 722 on the fifth temporary substrate 721, the fifth intermediate insulating layer 722 may be formed in the third direction DR3 from the fifth temporary substrate 721.

Each of the fourth and fifth temporary substrates 711 and 721 may be configured of a sapphire substrate, a silicon (Si) substrate, a silicon carbide (SiC) substrate, or the like. However, embodiments of the disclosure are not limited to the foregoing example. For example, each of the fourth and fifth temporary substrates 711 and 721 may be formed using a single-crystal substrate having a lattice structure, or the like. Each of the fourth and fifth temporary substrates 711 and 721 may further include a buffer layer formed on one surface thereof.

Each of the fourth and fifth intermediate insulating layers 712 and 722 may be configured of an inorganic insulating layer. For example, each of the fourth and fifth intermediate insulating layers 712 and 722 may include inorganic material such as silicon oxide (SiOₓ), silicon nitride (SiNₓ), silicon oxynitride (SiOₓN_{y}), silicon oxycarbide (SiOₓC_{y}), aluminium oxide (AlOₓ), aluminium nitride (AlNₓ), zirconium oxide (ZrOₓ), hafnium oxide (HfOₓ), or titanium oxide (TiOₓ). However, embodiments of the disclosure are not limited to the foregoing example.

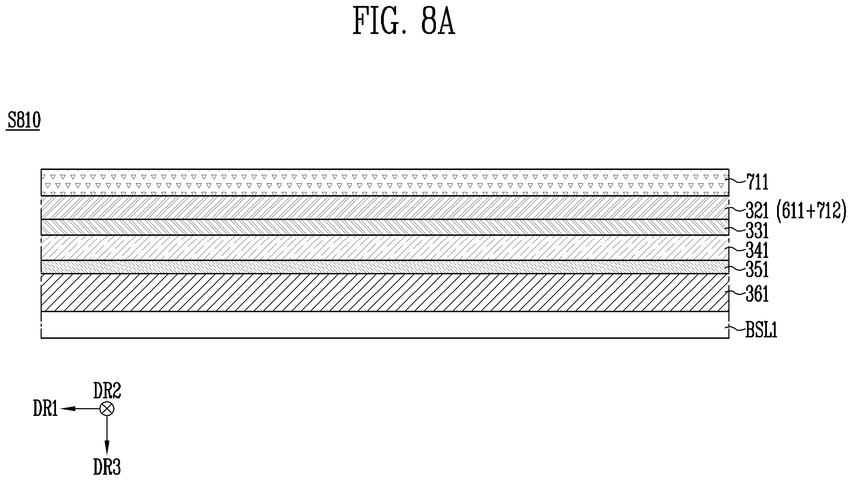

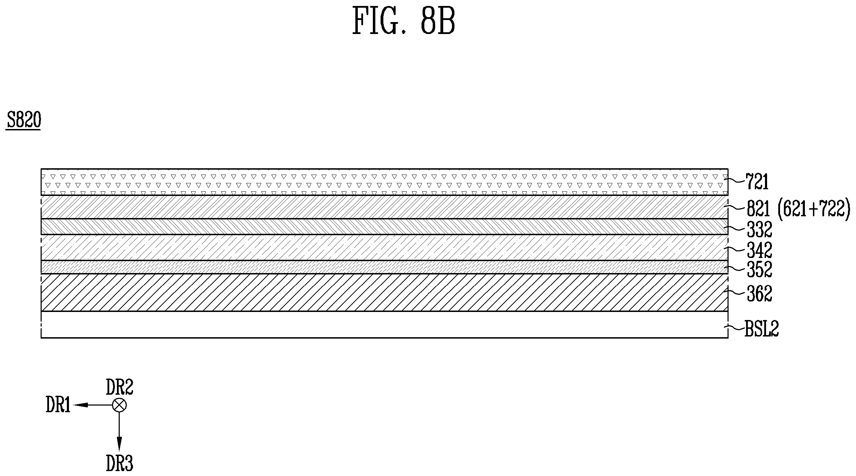

Referring to FIGS. 8A to 8B, there is illustrated the step of bonding the insulating layers (for example, the intermediate insulating layer).

The method of fabricating the display panel in accordance with embodiments of the disclosure may include step S810 of bonding the first intermediate insulating layer 611 and the fourth intermediate insulating layer 712, and step S820 of bonding the second intermediate insulating layer 621 and the fifth intermediate insulating layer 722.

At step S810 of bonding the first intermediate insulating layer 611 and the fourth intermediate insulating layer 712, the first insulating layer 321 may be formed by bonding the first intermediate insulating layer 611 and the fourth intermediate insulating layer 712 to each other. The fourth temporary substrate 711 may be disposed in a direction opposite to the third direction DR3 from the first insulating layer 321.

At step S820 of bonding the second intermediate insulating layer 621 and the fifth intermediate insulating layer 722, a sixth intermediate insulating layer 821 may be formed by bonding second intermediate insulating layer 621 and the fifth intermediate insulating layer 722 to each other. The fifth temporary substrate 721 may be disposed in a direction opposite to the third direction DR3 from the sixth intermediate insulating layer 821.

At the step of bonding the intermediate insulating layers, the insulating layers (e.g., the second intermediate insulating layer 621 and the fifth intermediate insulating layer 722) may be bonded to each other using heat, pressure, and/or the like. However, embodiments of the disclosure are not limited to the foregoing example.

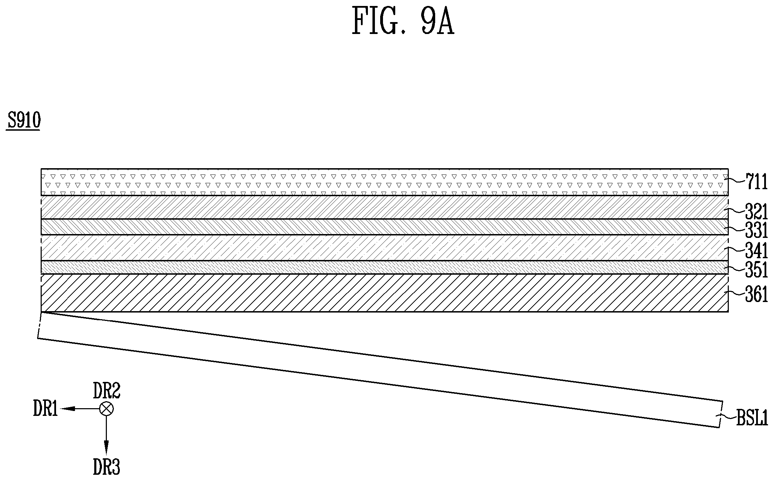

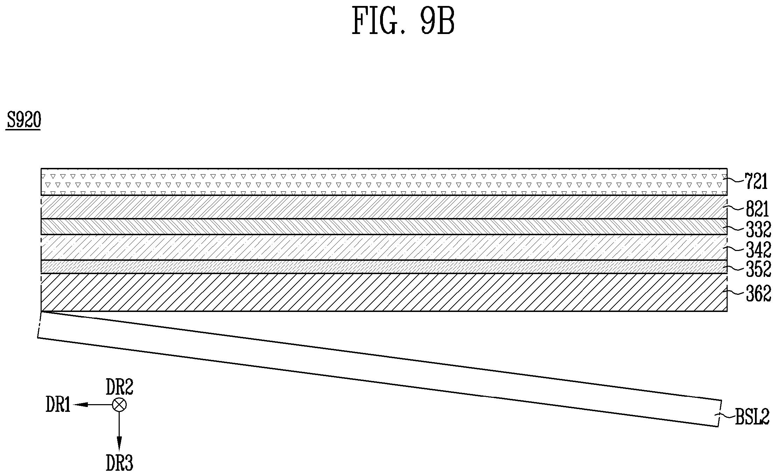

Referring to FIGS. 9A and 9B, there is illustrated the step of removing the temporary substrate.

The method of fabricating the display panel in accordance with embodiments of the disclosure may include step S910 of removing the first temporary substrate BSL1, and step S920 of removing the second temporary substrate BSL2.

For example, at step S910 of removing the first temporary substrate BSL1, the first temporary substrate BSL1 may be separated from the 1-th second semiconductor layer 361 through a laser lift-off (LLO) process. For example, at step S920 of removing the second temporary substrate BSL2, the second temporary substrate BSL2 may be separated from the 2-th second semiconductor layer 362 through a laser lift-off (LLO) process. However, embodiments of the disclosure are not limited to the foregoing example.

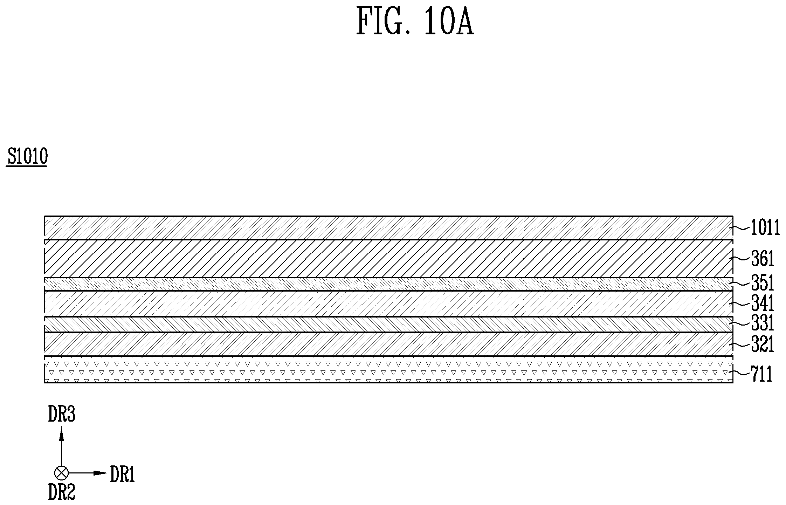

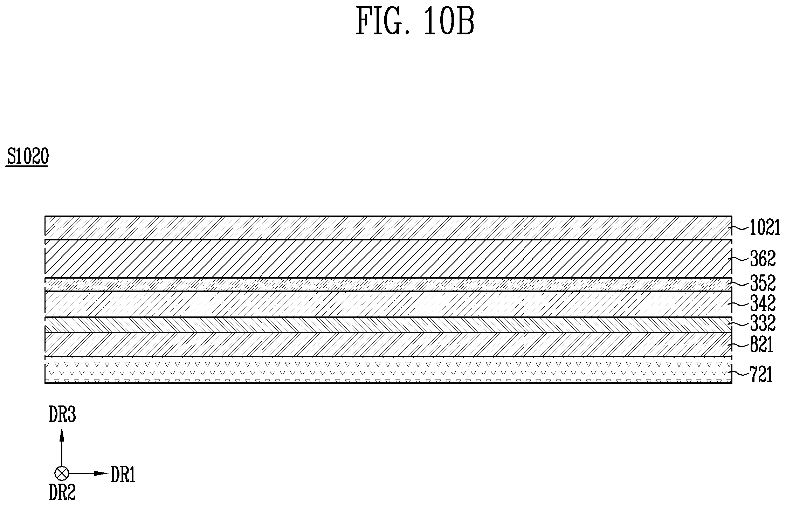

Referring to FIGS. 10A and 10B, there is illustrated the step of forming an insulating layer (for example, an intermediate insulating layer) on the temporary substrate.

The method of fabricating the display panel in accordance with embodiments of the disclosure may include step S1010 of forming a seventh intermediate insulating layer 1011 on the first emission layer, and step S1020 of forming an eighth intermediate insulating layer 1021 on the second emission layer.

At step S1010 of forming the seventh intermediate insulating layer 1011 on the first emission layer, the seventh intermediate insulating layer 1011 may be formed in the third direction DR3 from the 1-th second semiconductor layer 361.

At step S1020 of forming the eighth intermediate insulating layer 1021 on the second emission layer, the eighth intermediate insulating layer 1021 may be formed in the third direction DR3 from the 2-th second semiconductor layer 362.

Each of the seventh and eighth intermediate insulating layers 1011 and 1021 may be configured of an inorganic insulating layer. For example, each of the seventh and eighth intermediate insulating layers 1011 and 1021 may include inorganic material such as silicon oxide (SiOₓ), silicon nitride (SiNₓ), silicon oxynitride (SiOₓN_{y}), silicon oxycarbide (SiOₓC_{y}), aluminium oxide (AlOₓ), aluminium nitride (AlNₓ), zirconium oxide (ZrOₓ), hafnium oxide (HfOₓ), or titanium oxide (TiOₓ). However, embodiments of the disclosure are not limited to the foregoing example.

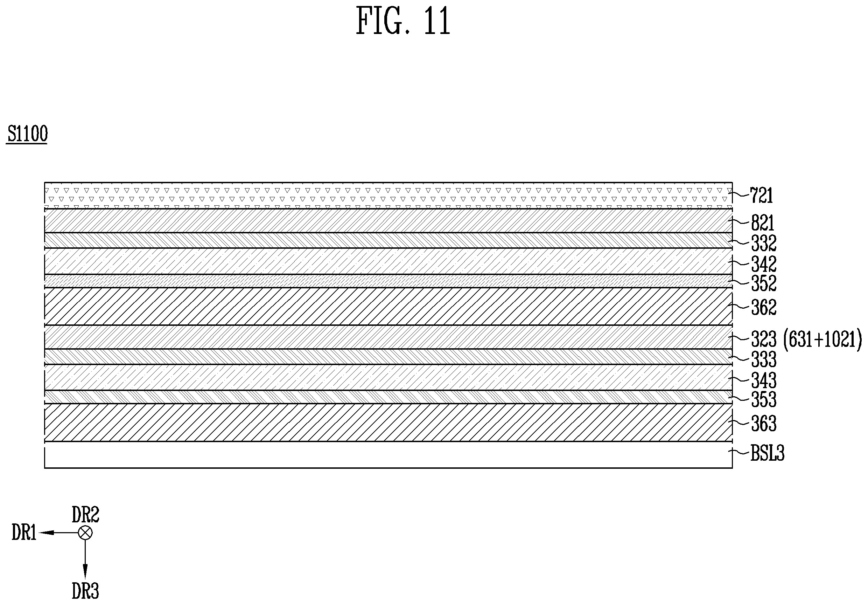

Referring to FIG. 11, there is illustrated the step of bonding the insulating layers (for example, the intermediate insulating layer).

The method of fabricating the display panel in accordance with embodiments of the disclosure may include step S1100 of bonding the third intermediate insulating layer 631 and the eighth intermediate insulating layer 1021.

At step S1100 of bonding the third intermediate insulating layer 631 and the eighth intermediate insulating layer 1021, the third insulating layer 323 may be formed by bonding the third intermediate insulating layer 631 and the eighth intermediate insulating layer 1021 to each other. The fifth temporary substrate 721 may be disposed in a direction opposite to the third direction DR3 from the third insulating layer 323.

At the step of bonding the intermediate insulating layers, the insulating layers (e.g., the third intermediate insulating layer 631 and the eighth intermediate insulating layer 1021) may be bonded to each other using heat, pressure, and/or the like. However, embodiments of the disclosure are not limited to the foregoing example.

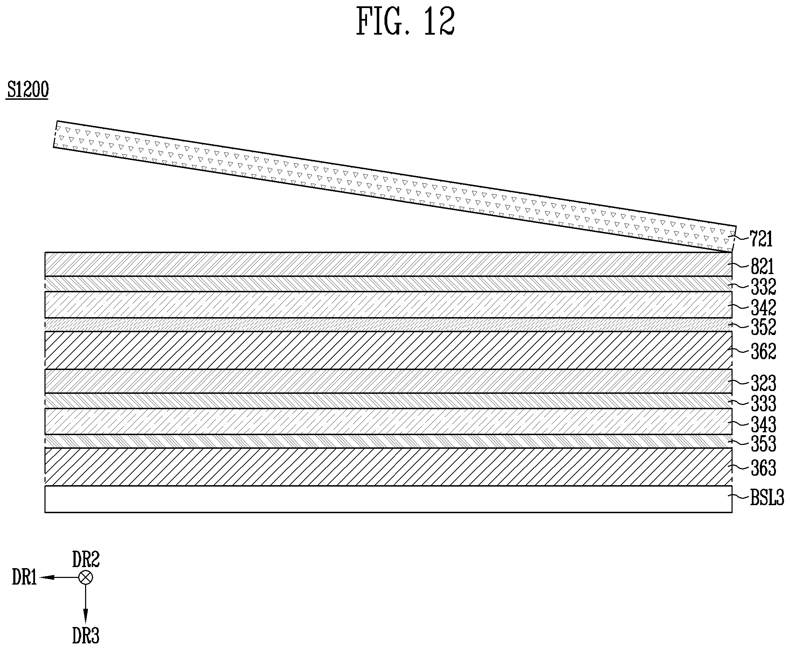

Referring to FIG. 12, there is illustrated the step of removing the temporary substrate.

The method of fabricating the display panel in accordance with embodiments of the disclosure may include step S1200 of removing the fifth temporary substrate 721. At step S1200 of removing the fifth temporary substrate 721, the fifth temporary substrate 721 may be separated from the sixth intermediate insulating layer 821.

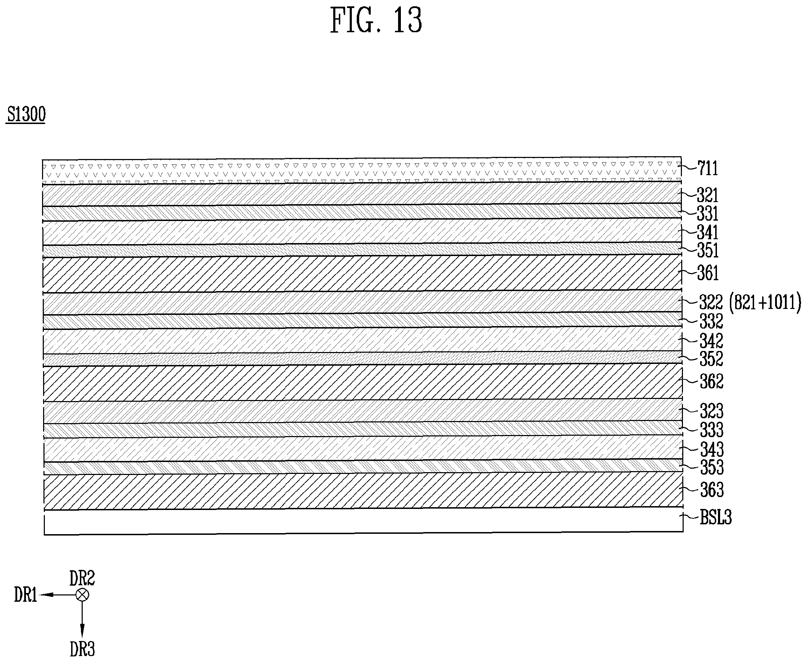

Referring to FIG. 13, there is illustrated the step of bonding the insulating layers (for example, the intermediate insulating layer).

The method of fabricating the display panel in accordance with embodiments of the disclosure may include step S1300 of bonding the sixth intermediate insulating layer 821 and the seventh intermediate insulating layer 1011.

At step S1300 of bonding the sixth intermediate insulating layer 821 and the seventh intermediate insulating layer 1011, the second insulating layer 322 may be formed by bonding the sixth intermediate insulating layer 821 and the seventh intermediate insulating layer 1011 to each other. The fourth temporary substrate 711 may be disposed in a direction opposite to the third direction DR3 from the second insulating layer 322.

At the step of bonding the intermediate insulating layers, the insulating layers (e.g., the sixth intermediate insulating layer 821 and the seventh intermediate insulating layer 1011) may be bonded to each other using heat, pressure, and/or the like. However, embodiments of the disclosure are not limited to the foregoing example.

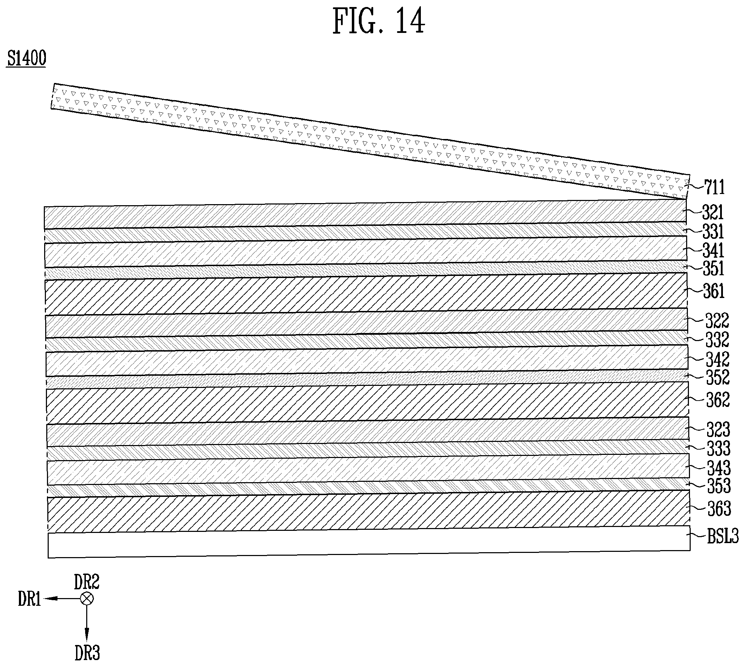

Referring to FIG. 14, there is illustrated the step of removing the temporary substrate.

The method of fabricating the display panel in accordance with embodiments of the disclosure may include step S1400 of removing the fourth temporary substrate 711. At step S1400 of removing the fourth temporary substrate 711, the fourth temporary substrate 711 may be separated from the first insulating layer 321.

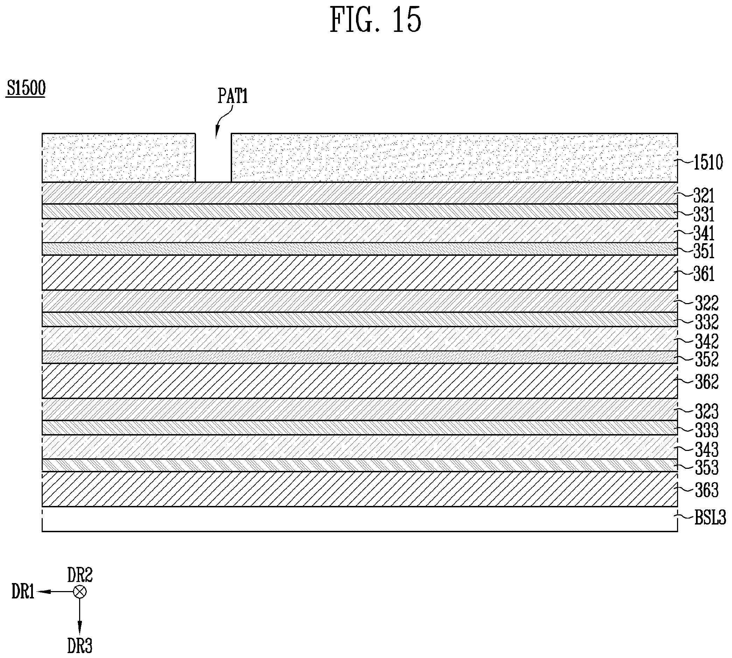

Referring to FIGS. 15 to 20, there is illustrated the step of forming first, second, and third via holes VIA1, VIA2, and VIA3 using a photoresist.

The method of fabricating the display panel in accordance with embodiments of the disclosure may include step S1500 of forming a first photoresist layer 1510 including a first pattern PAT1, step S1600 of forming a first via hole VIA1 corresponding to the first pattern PAT1, step S1700 of forming a second photoresist layer 1710 including a second pattern PAT2, step S1800 of forming a second via hole VIA2 corresponding to the second pattern PAT2, step S1900 of forming a third photoresist layer 1910 including a third pattern PAT3, and step S2000 of forming a third via hole VIA3 corresponding to the third pattern PAT3.

At step S1500 of forming the first photoresist layer 1510 including the first pattern PAT1, the first pattern PAT1 may be formed in the first photoresist layer 1510 using a photo mask (not shown) with a pattern corresponding to the first pattern PAT1. The first photoresist layer 1510, for example, may be formed of either a positive photoresist or a negative photoresist.

At step S1600 of forming the first via hole VIA1, the first via hole VIA1 may be formed in an area corresponding to the first pattern PAT1. The first via hole VIA1 may pass through at least respective portions of the first insulating layer 321, the first transmissive conductive layer 331, the 1-th first semiconductor layer 341, the first active layer 351, the 1-th second semiconductor layer 361, the second insulating layer 322, the second transmissive conductive layer 332, the 2-th first semiconductor layer 342, the second active layer 352, the 2-th second semiconductor layer 362, the third insulating layer 323, the third transmissive conductive layer 333, the 3-th first semiconductor layer 343, and the third active layer 353. The first via hole VIA1 may be formed through a dry etching process, but embodiments of the disclosure are not limited thereto. For example, the first via hole VIA1 may be formed through a wet etching process. In the case where the first via hole VIA1 in accordance with embodiments of the disclosure is formed through the dry etching process, the first via hole VIA1 may be formed through a process such as vapor etching, plasma etching, ion beam etching, or the like.

At step S1700 of forming the second photoresist layer 1710 including the second pattern PAT2, the second pattern PAT2 may be formed in the second photoresist layer 1710 using a photo mask (not shown) with a pattern corresponding to the second pattern PAT2. The second photoresist layer 1710, for example, may be formed of either a positive photoresist or a negative photoresist. In an embodiment, the first via hole VIA1 may be filled with the second photoresist layer 1710, but embodiments of the disclosure are not limited thereto.

At step S1800 of forming the second via hole VIA2, the second via hole VIA2 may be formed in an area corresponding to the second pattern PAT2. The second via hole VIA2 may pass through at least respective portions of the first insulating layer 321, the first transmissive conductive layer 331, the 1-th first semiconductor layer 341, the first active layer 351, the 1-th second semiconductor layer 361, the second insulating layer 322, the second transmissive conductive layer 332, the 2-th first semiconductor layer 342, and the second active layer 352. The second via hole VIA2 may be formed through a dry etching process, but embodiments of the disclosure are not limited thereto. For example, the second via hole VIA2 may be formed through a wet etching process.

At step S1900 of forming the third photoresist layer 1910 including the third pattern PAT3, the third pattern PAT3 may be formed in the third photoresist layer 1910 using a photo mask (not shown) with a pattern corresponding to the third pattern PAT3. The third photoresist layer 1910, for example, may be formed of either a positive photoresist or a negative photoresist. In an embodiment, the first and/or second via holes VIA1 and/or VIA2 may be filled with the third photoresist layer 1910, but embodiments of the disclosure are not limited thereto.

At step S2000 of forming the third via hole VIA3, the third via hole VIA3 may be formed in an area corresponding to the third pattern PAT3. The third via holes VIA3 may pass through at least respective portions of the first insulating layer 321, the first transmissive conductive layer 331, the 1-th first semiconductor layer 341, and the first active layer 351. The third via hole VIA3 may be formed through a dry etching process, but embodiments of the disclosure are not limited thereto. For example, the third via hole VIA3 may be formed through a wet etching process.

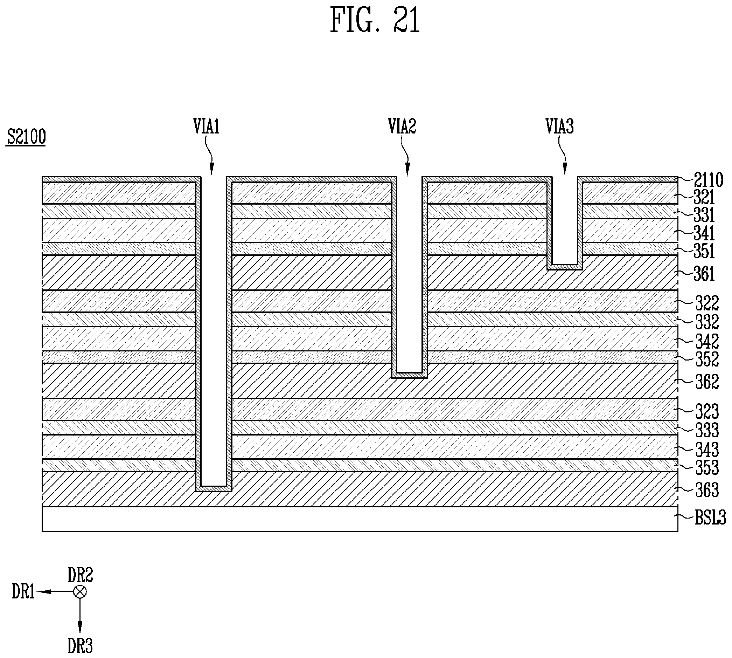

Referring to FIGS. 21 to 23, there is illustrated an embodiment of the step of forming the light blocking layer. For example, at the step of forming the light blocking layer, an electroplating process (e.g., a damascene process) may be performed, or a deposition process may be performed.

In an embodiment, the light blocking layer may be formed by an electroplating method. For example, the light blocking layer may be formed by electroplating copper (Cu) or the like into the first to third via holes VIA1, VIA2, and VIA3 through a damascene process.

In an embodiment, the light blocking layer may be formed by a deposition method. For example, the light blocking layer may be formed by a method of depositing tungsten (W) into the first to third via holes VIA1, VIA2, and VIA3. For example, chemical vapor deposition (CVD), physical vapor deposition (PVD), atomic layer deposition (ALD), or the like may be applied to the deposition process. However, embodiments of the disclosure are not limited to the aforementioned example.

The following description will be focused on an embodiment where the damascene process is applied to the step of forming the light blocking layer. However, embodiments of the disclosure are not limited to the aforementioned example, and processes other than the damascene process, such as electroplating or deposition processes, may be applied to form the light blocking layer.

Referring to FIGS. 21 to 23, the method of fabricating the display panel in accordance with embodiments of the disclosure may include step 2100 of forming a first passivation layer 2110 enclosing the first to third via holes VIA1, VIA2, and VIA3, step S2200 of electroplating a metal layer 2210 into the first to third via holes VIA1, VIA2, and VIA3 enclosed by the first passivation layer 2110, and step S2300 of forming a light blocking layer 370.

The passivation layer 2110 may include, for example, inorganic materials such as silicon oxide (SiOₓ), silicon nitride (SiNₓ), silicon oxynitride (SiOₓN_{y}), silicon oxycarbide (SiOₓC_{y}), aluminium oxide (AlOₓ), aluminium nitride (AlNₓ), zirconium oxide (ZrOₓ), hafnium oxide (HfOₓ), or titanium oxide (TiOₓ). However, embodiments of the disclosure are not limited to the foregoing example. The first passivation layer 2110 may be disposed on an upper surface of the first insulating layer 321. The first passivation layer 2110 may enclose layers exposed on the sides of the first to third via holes VIA1, VIA2, and VIA3.

The metal layer 2210 may form the light blocking layer 370. The metal layer 2210 may be unrestrictedly selected by those skilled in the art. For example, so long as the internal space of first to third via holes VIA1, VIA2, and VIA3 can be filled with the metal layer 2210 by the electroplating method through the damascene process, the metal layer 2210 may be unrestrictedly selected by those skilled in the art. The metal layer 2210, for example, may be formed of copper (Cu), but embodiments of the disclosure are not limited thereto. For example, metal having a relatively lower reflectance than copper (Cu) may be used, thus absorbing incident light, thereby enhancing light blocking performance. As another example, metal having a relatively higher reflectance than copper (Cu) may be used to reflect incident light toward a top side, thus increasing the luminance.

At step S2300 of forming the light blocking layer 370, the metal layer 2210 that is disposed on the first passivation layer 2110 may be removed.

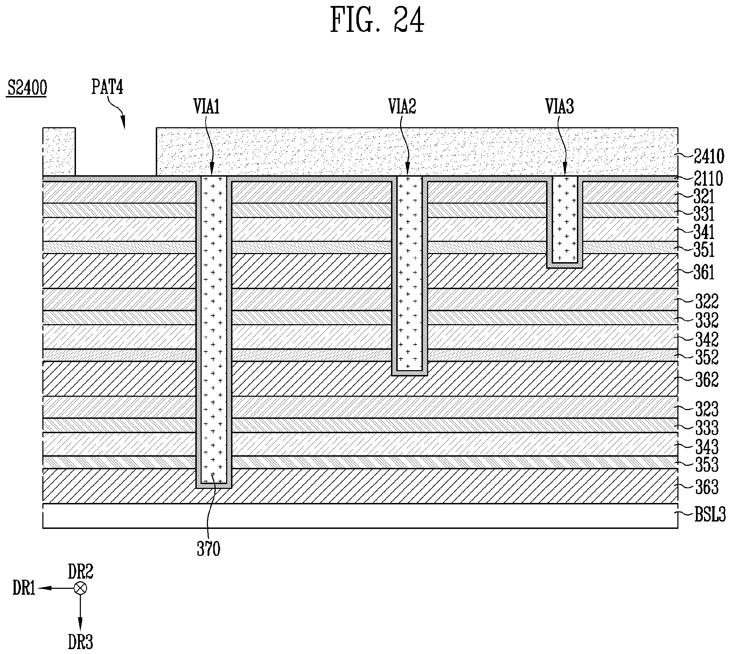

Referring to FIGS. 24 to 29, there is illustrated the step of forming first, second, and third contact holes CNT1, CNT2, and CNT3 using a photoresist.

The method of fabricating the display panel in accordance with embodiments of the disclosure may include step S2400 of forming a fourth photoresist layer 2410 including a fourth pattern PAT4, step S2500 of forming a first contact hole CNT1 corresponding to the fourth pattern PAT4, step S2600 of forming a fifth photoresist layer 2610 including a fifth pattern PAT5, step S1800 of forming a second contact hole CNT2 corresponding to the fifth pattern PAT5, step S2800 of forming a sixth photoresist layer 2810 including a sixth pattern PAT6, and step S2900 of forming a third contact hole CNT3 corresponding to the sixth pattern PAT6.

At step S2400 of forming the fourth photoresist layer 2410 including the fourth pattern PAT4, the fourth pattern PAT4 may be formed in the fourth photoresist layer 2410 using a photo mask (not shown) with a pattern corresponding to the fourth pattern PAT4. The fourth photoresist layer 2410, for example, may be formed of either a positive photoresist or a negative photoresist.

At step S2500 of forming the first contact hole CNT1, the first contact hole CNT1 may be formed in an area corresponding to the fourth pattern PAT4. The first contact hole CNT1 may pass through at least respective portions of the first insulating layer 321, the first transmissive conductive layer 331, the 1-th first semiconductor layer 341, the first active layer 351, the 1-th second semiconductor layer 361, the second insulating layer 322, the second transmissive conductive layer 332, the 2-th first semiconductor layer 342, the second active layer 352, the 2-th second semiconductor layer 362, the third insulating layer 323. The first contact hole CNT1 may expose at least a portion of the third transmissive conductive layer 333. The first contact hole CNT1 may be formed through a dry etching process, but embodiments of the disclosure are not limited thereto. For example, the first contact hole CNT1 may be formed through a wet etching process. In the case where the first contact hole CNT1 in accordance with embodiments of the disclosure is formed through the dry etching process, the first contact hole CNT1 may be formed through a process such as vapor etching, plasma etching, ion beam etching, or the like.

At step S2600 of forming the fifth photoresist layer 2610 including the fifth pattern PAT5, the fifth pattern PAT5 may be formed in the fifth photoresist layer 2610 using a photo mask (not shown) with a pattern corresponding to the fifth pattern PAT5. The fifth photoresist layer 2610, for example, may be formed of either a positive photoresist or a negative photoresist. In an embodiment, the first contact hole CNT1 may be filled with the fifth photoresist layer 2610, but embodiments of the disclosure are not limited thereto.

At step S2700 of forming the second contact hole CNT2, the second contact hole CNT2 may be formed in an area corresponding to the fifth pattern PAT5. The second contact hole CNT2 may pass through at least respective portions of the first insulating layer 321, the first transmissive conductive layer 331, the 1-th first semiconductor layer 341, the first active layer 351, the 1-th second semiconductor layer 361, and the second insulating layer 322. The second contact hole CNT2 may expose at least a portion of the second transmissive conductive layer 332. The second contact hole CNT2 may be formed through a dry etching process, but embodiments of the disclosure are not limited thereto. For example, the second contact hole CNT2 may be formed through a wet etching process.

At step S2800 of forming the sixth photoresist layer 2810 including the sixth pattern PAT6, the sixth pattern PAT6 may be formed in the sixth photoresist layer 2810 using a photo mask (not shown) with a pattern corresponding to the sixth pattern PAT6. The sixth photoresist layer 2810, for example, may be formed of either a positive photoresist or a negative photoresist. In an embodiment, the first and/or second contact holes CNT1 and/or CNT2 may be filled with the sixth photoresist layer 2810, but embodiments of the disclosure are not limited thereto.

At step S2900 of forming the third contact hole CNT3, the third contact hole CNT3 may be formed in an area corresponding to the sixth pattern PAT6. The third contact hole CNT3 may penetrate at least a portion of the first insulating layer 321. The third contact hole CNT3 may expose at least a portion of the first transmissive conductive layer 331. The third contact hole CNT3 may be formed through a dry etching process, but embodiments of the disclosure are not limited thereto. For example, the third contact hole CNT3 may be formed through a wet etching process.

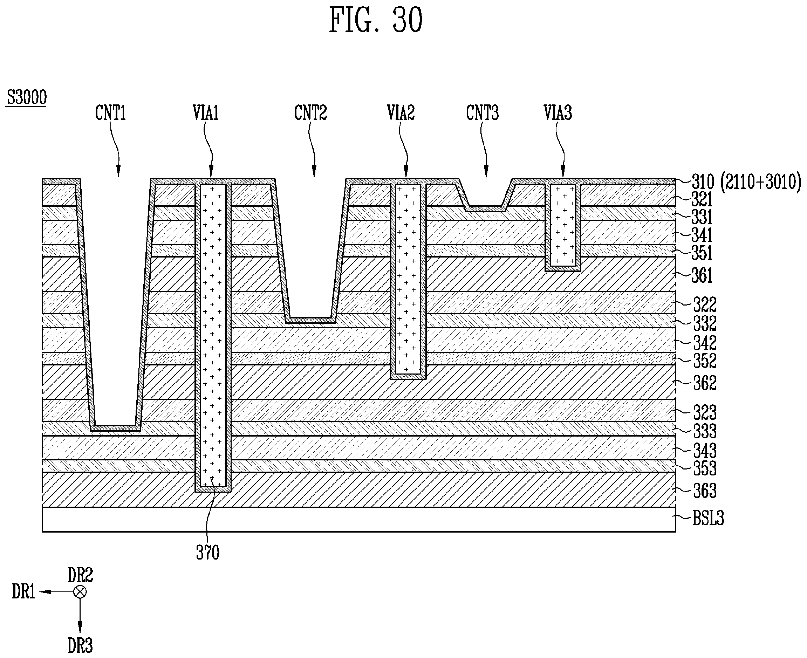

Referring to FIG. 30, there is illustrated the step of forming a passivation layer (e.g., a second passivation layer 3010).

The method of fabricating the display panel in accordance with embodiments of the disclosure may include the step S3000 of forming the second passivation layer 3010. The second passivation layer 3010, along with the first passivation layer 2110, may form the passivation layer 310. The second passivation layer 3010 may be formed of a same material as the first passivation layer 2110. The second passivation layer 3010 may include, for example, inorganic materials such as silicon oxide (SiOₓ), silicon nitride (SiNₓ), silicon oxynitride (SiOₓN_{y}), silicon oxycarbide (SiOₓC_{y}), aluminium oxide (AlOₓ), aluminium nitride (AlNₓ), zirconium oxide (ZrOₓ), hafnium oxide (HfOₓ), or titanium oxide (TiOₓ). However, embodiments of the disclosure are not limited to the foregoing example.

The second passivation layer 3010 may enclose the first to third contact holes CNT1, CNT2, and CNT3. The second passivation layer 3010 may cover an upper surface of the light blocking layer 370. For example, the second passivation layer 3010 may be disposed in a direction opposite to the third direction DR3 from the light blocking layer 370.

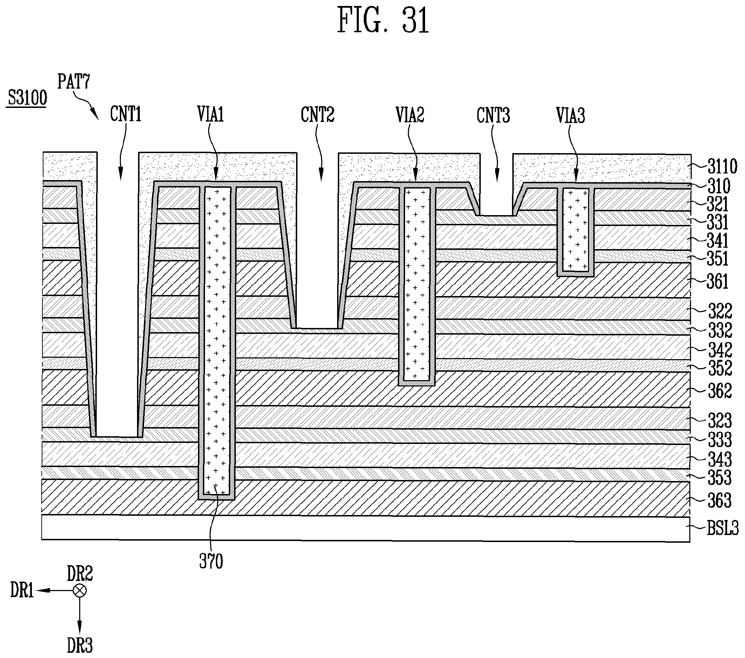

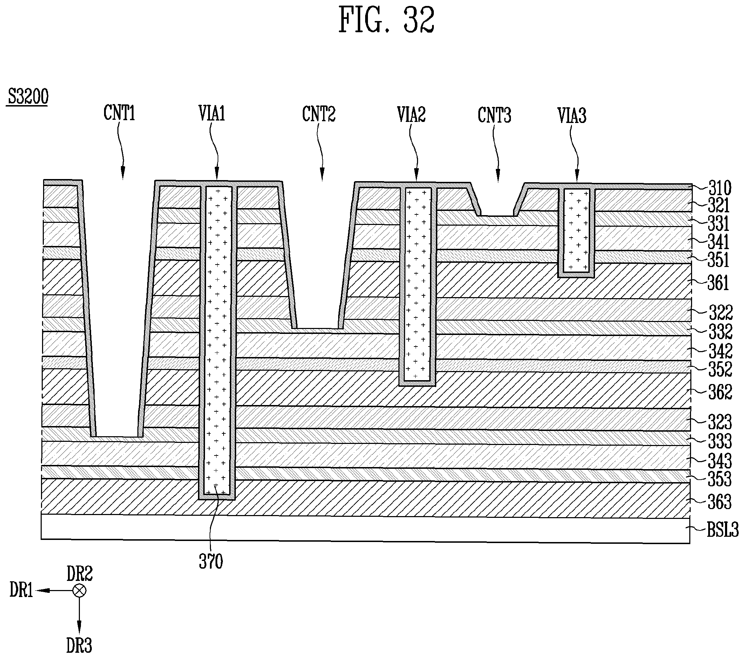

Referring to FIGS. 31 and 32, there is illustrated the step of exposing at least a portion of the transmissive conductive layer.

The method of fabricating the display panel in accordance with embodiments of the disclosure may include step S3100 of forming a seventh photoresist layer 3110 including a seventh pattern PAT7, and step S3200 of exposing the first to third transmissive conductive layers 331, 332, and 333 in an area corresponding to the seventh pattern PAT7.

At step S3100 of forming the seventh photoresist layer 3110 including the seventh pattern PAT7, the seventh pattern PAT7 may be formed in the seventh photoresist layer 3110 using a photo mask (not shown) with a pattern corresponding to the seventh pattern PAT7. The seventh photoresist layer 3110, for example, may be formed of either a positive photoresist or a negative photoresist.

At step S3200 of exposing the first to third transmissive conductive layers 331, 332, and 333, at least a portion of the passivation layer 310 is removed from the bottom of each of the first to third contact holes CNT1 to CNT3. At least a portion of the third transmissive conductive layer 333 may be exposed through the bottom of the first contact holes CNT1. At least a portion of the second transmissive conductive layer 332 may be exposed through the bottom of the second contact holes CNT2. At least a portion of the first transmissive conductive layer 331 may be exposed through the bottom of the third contact holes CNT3. Although a dry etching process may be performed to remove at least a portion of the passivation layer 310, embodiments of the disclosure are not limited thereto.

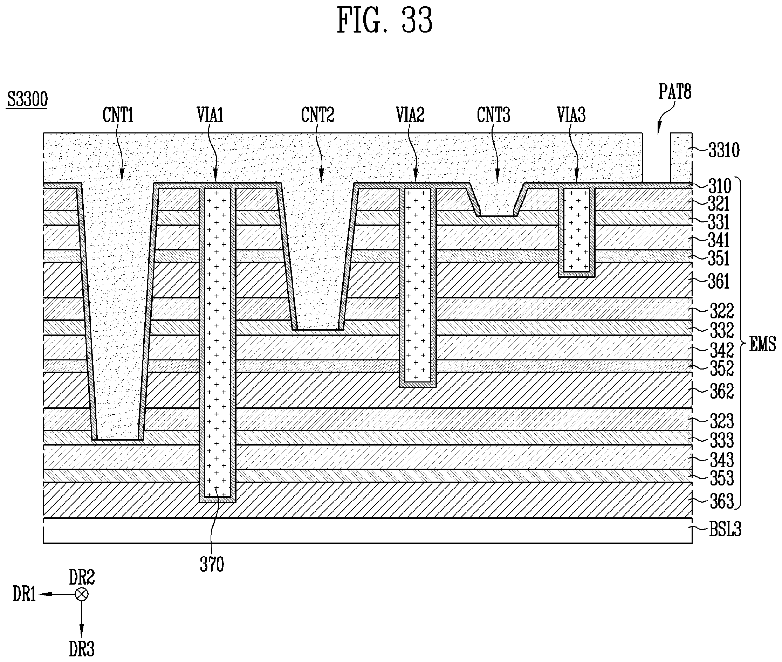

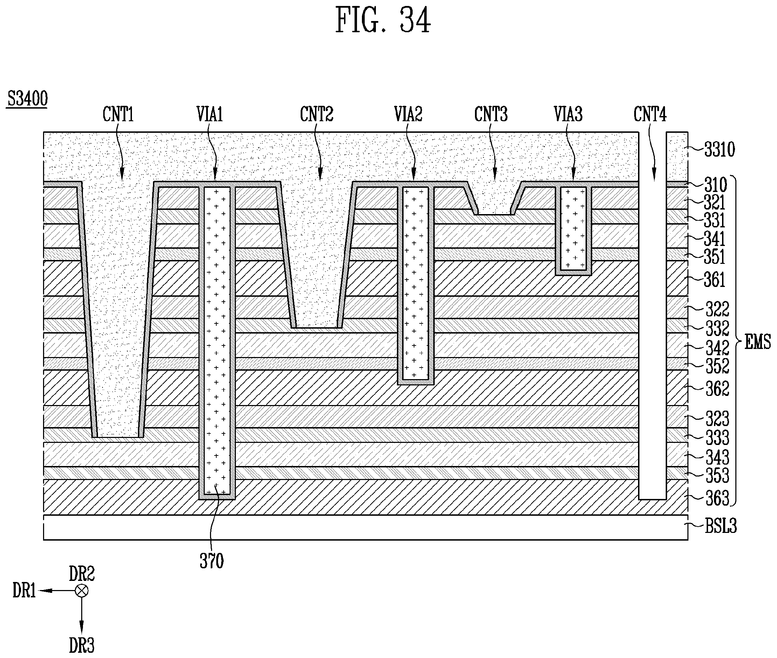

Referring to FIGS. 33 and 34, there is illustrated the step of forming a fourth contact hole CNT4.

The method of fabricating the display panel in accordance with embodiments of the disclosure may include step S3300 of forming an eighth photoresist layer 3310 including an eighth pattern PAT8, and step S3400 of forming a fourth contact hole CNT4 corresponding to the eighth pattern PAT8.

At step S3300 of forming the eighth photoresist layer 3310 including the eighth pattern PAT8, the eighth pattern PAT8 may be formed in the eighth photoresist layer 3310 using a photo mask (not shown) with a pattern corresponding to the eighth pattern PAT8. The eighth photoresist layer 3310, for example, may be formed of either a positive photoresist or a negative photoresist. The first to third contact holes CNT1 to CNT3 may be filled with the eighth photoresist layer 3310.

At step S3400 of forming the fourth contact hole CNT4, the fourth contact hole CNT4 may be formed in an area corresponding to the eighth pattern PAT8. The fourth contact hole CNT4 may pass through at least respective portions of the first insulating layer 321, the first transmissive conductive layer 331, the 1-th first semiconductor layer 341, the first active layer 351, the 1-th second semiconductor layer 361, the second insulating layer 322, the second transmissive conductive layer 332, the 2-th first semiconductor layer 342, the second active layer 352, the 2-th second semiconductor layer 362, the third insulating layer 323, the third transmissive conductive layer 333, and the third active layer 353. The fourth contact hole CNT4 may be formed by etching at least a portion of the 3-th second semiconductor layer 363. The fourth contact hole CNT4 may be formed through a dry etching process, but embodiments of the disclosure are not limited thereto. For example, the fourth contact hole CNT4 may be formed through a wet etching process. In the case where the fourth contact hole CNT4 in accordance with embodiments of the disclosure is formed through the dry etching process, the fourth contact hole CNT4 may be formed through a process such as vapor etching, plasma etching, ion beam etching, or the like.

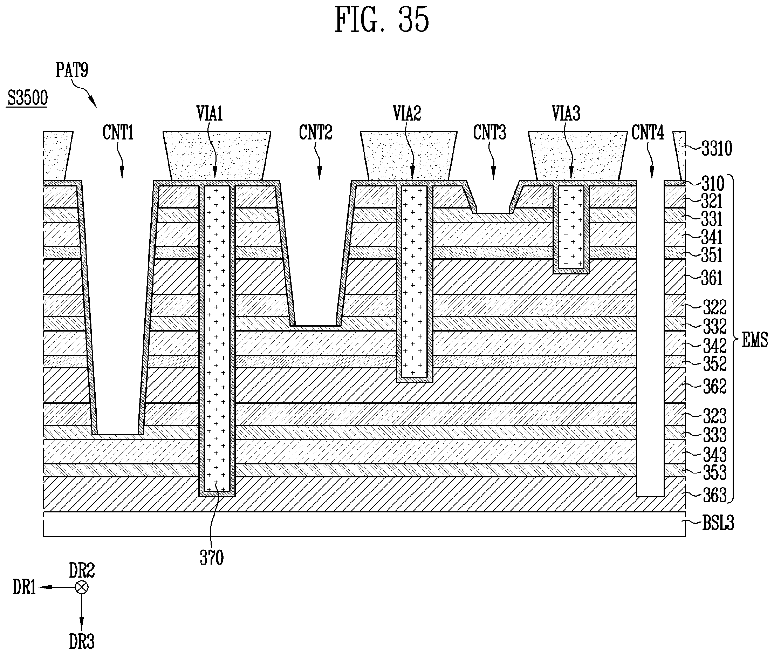

Referring to FIGS. 35 to 37, there is illustrated the step of forming first and second electrodes.

The method of fabricating the display panel in accordance with embodiments of the disclosure may include step S3500 of forming the eighth photoresist layer 3310 including a ninth pattern PAT9, step S3600 of depositing a metal layer 3610, and step S3700 of forming the first and second electrodes.

At step S3500 of forming the eighth photoresist layer 3310 including the ninth pattern PAT9, the ninth pattern PAT9 may be formed in the eighth photoresist layer 3310 using a photo mask (not shown) with a pattern corresponding to the ninth pattern PAT9. The ninth pattern PAT9 may be formed to correspond to the first to third contact holes CNT1 to CNT3. In an embodiment, the ninth pattern PAT9 may be formed to correspond also to the fourth contact hole CNT4.

At step S3600 of depositing the metal layer 3610, the metal layer 3610 may be deposited into the first to fourth contact holes CNT1 to CNT4. For example, the metal layer 3610 may include at least one of various transparent conductive materials including indium tin oxide (ITO), indium zinc oxide (IZO), indium tin zinc oxide (ITZO), aluminium zinc oxide (AZO), gallium zinc oxide (GZO), zinc tin oxide (ZTO), or gallium tin oxide (GTO). The metal layer 3610 may be implemented to be substantially transparent or translucent to satisfy a certain level of light transmittance. At step S3600 of depositing the metal layer 3610, a process such as physical vapor deposition (PVD) or a chemical vapor deposition (CVD) may be performed.

At step S3700 of forming the first and second electrodes, the eighth photoresist layer 3310 may be removed. As the eighth photoresist layer 3310 is removed, the metal layer 3610 deposited on the eighth photoresist layer 3310 may be removed together therewith. An a-th first electrode ET1a may be formed in the third contact hole CNT3. A b-th first electrode ET1b may be formed in the second contact hole CNT2. A c-th first electrode ET1c may be formed in the first contact hole CNT1.

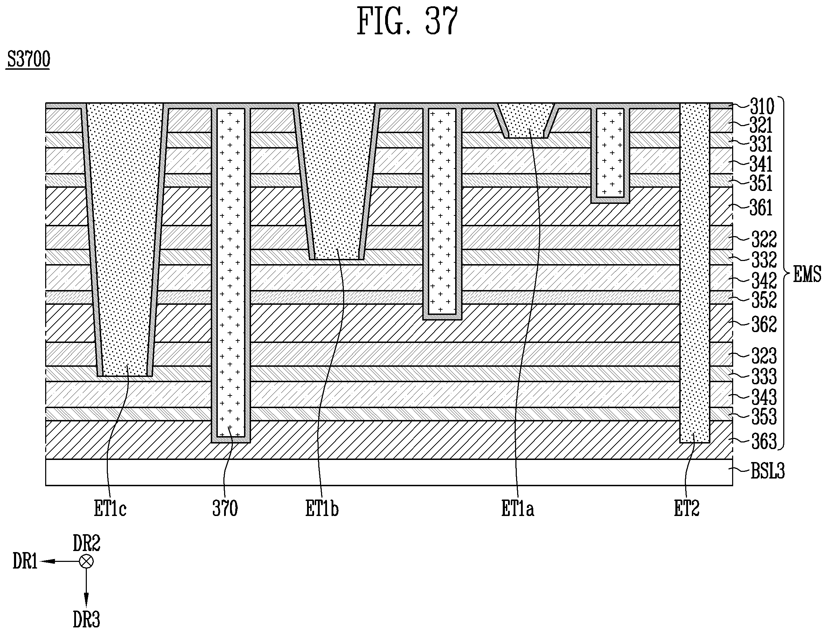

Referring to FIG. 37, the emission structure EMS may be formed on the third temporary substrate BSL3. The emission structure EMS may include the first to third emission layers, the first to third transmissive conductive layers 331, 332, and 333, the first to third insulating layers 321, 322, and 323, the passivation layer 310, and so on.

The emission structure EMS may further include the light blocking structure. The light blocking layer 370 may function to prevent light emitted from the respective pixels from being mixed with each other.

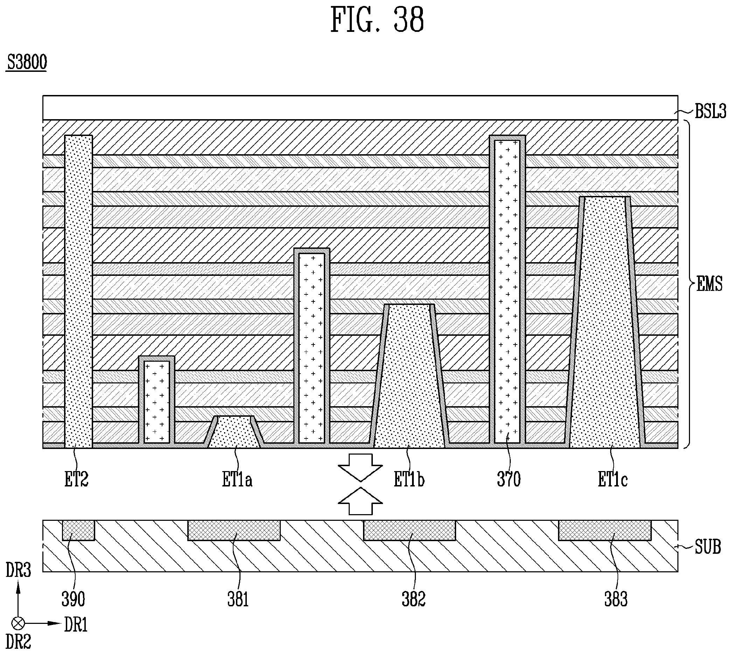

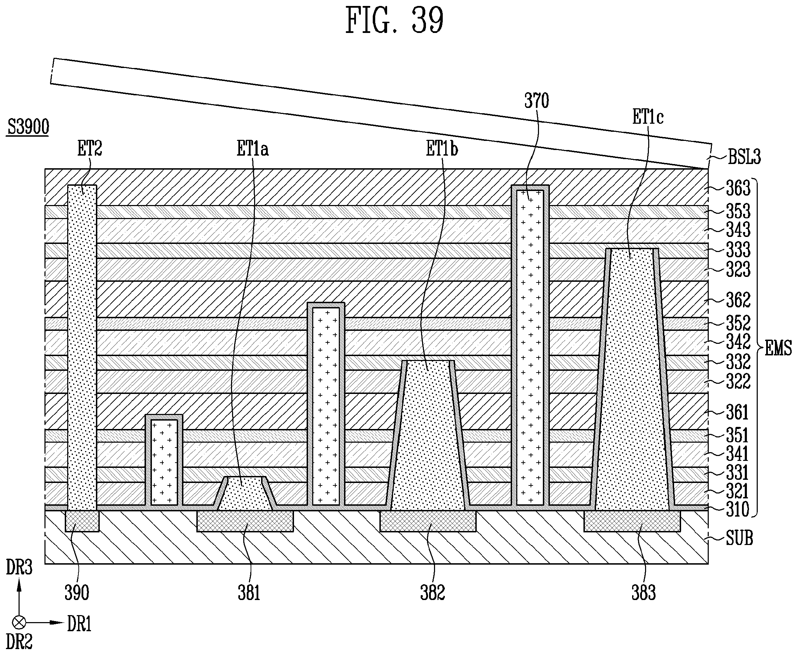

Referring to FIGS. 38 and 39, there is illustrated the step of making contact with the emission structure EMS.

The method of fabricating the display panel in accordance with embodiments of the disclosure may include step S3800 of bringing the emission structure EMS into contact with the substrate SUB, and step S3900 of removing the third temporary substrate BSL3.

At step S3800 of bringing the emission structure EMS into contact with the substrate SUB, the first electrode may be connected to the pixel circuit PXC (refer to FIG. 2), and the second electrode ET2 may be connected to the second power line PL2 (refer to FIG. 2). The a-th first electrode ET1a may be connected to the pixel circuit 381 of the first pixel PXL1. The b-th first electrode ET1b may be connected to the pixel circuit 382 of the second pixel PXL2. The c-th first electrode ET1c may be connected to the pixel circuit 383 of the third pixel PXL3. The second electrode ET2 may be connected to the second power line 390.

At step S3900 of removing the third temporary substrate BSL3, the third temporary substrate BSL3 may be separated from the 3-th second semiconductor layer 363. At step S3900 of removing the third temporary substrate BSL3, a laser lift-off process may be performed.

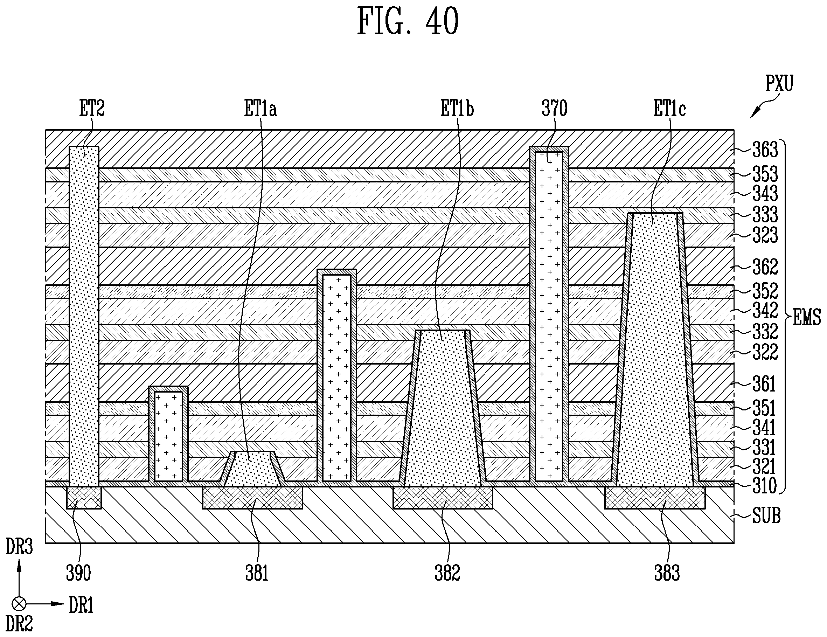

FIG. 40 is a schematic diagram illustrating a display panel fabricated according to FIGS. 4A to 39.

The display panel fabricated according to FIGS. 4A to 39 may be substantially the same as the display panel illustrated in FIG. 3.

Although FIG. 40 illustrates the emission structure EMS of a single unit pixel PXU, embodiments of the disclosure are not limited thereto. For example, the emission structures EMS of two or more unit pixels PXU may be integrally formed with each other and disposed on the substrate SUB.

In the display panel in accordance with embodiments of the disclosure, during a process of fabricating the emission structure EMS, a planarization layer using an organic insulating layer may not be used. Accordingly, it is possible for the emission structure EMS to have a thin structure. In addition, the time it takes to perform the etching process may be markedly reduced.

In accordance with embodiments of the disclosure, the emission structure EMS may be fabricated on a basis of the unit pixel PXU. As a result, it is possible to provide a display panel (or display device) capable of displaying high-resolution images.

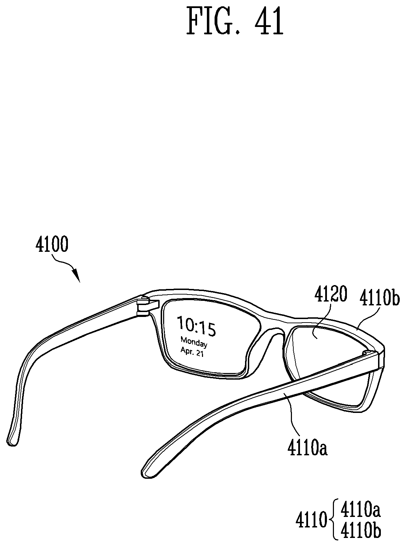

FIGS. 41 to 44 schematically illustrate examples of an electronic device in accordance with embodiments of the disclosure.

Referring to FIG. 41, the display device in accordance with the aforementioned embodiments may be applied to smart glasses 4100. The smart glasses 4100 may include a frame 4110 and a lens component 4120. The smart glasses 4100 are a wearable electronic device, which is worn on the face of the user, and may have a structure such that a portion of the frame 4110 can be folded or unfolded. For example, the smart glasses 4100 may be a wearable device for augmented reality (AR).

The frame 4110 may include a housing 4110b that supports the lens component 4120, and a leg component 4110a enabling the user to wear the smart glasses. The leg component 4110a is connected to the housing 4110b by a hinge and thus can be folded or unfolded.

The frame 4110 may be equipped with a battery, a touch pad, a microphone, and/or a camera. Furthermore, the frame 4110 may be equipped with a projector configured to output light, and/or a processor configured to control a light signal.

The lens component 4120 may be an optical component configured to transmit or reflect light. The lens component 4120 may include glass, and/or transparent synthetic resin.

The display device in accordance with the aforementioned embodiments may be applied to the lens component 4120. For example, the user may perceive images displayed by optical signals transmitted from the projector in the frame 4110 through the lens component 4120. For example, the user may perceive information such as time and date displayed on the lens component 4120.

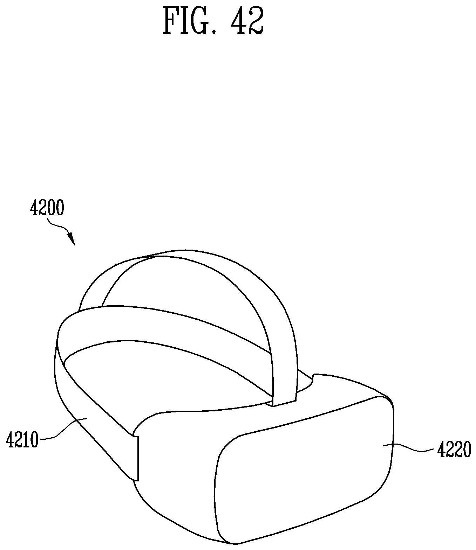

Referring to FIG. 42, the display device in accordance with the aforementioned embodiments may be applied to a head-mounted display (HMD) 4200. The HMD 4200 may include a head-mounted band 4210 and a display receiving casing 4220. For example, the HMD 4200 may be a wearable electronic device, which can be worn on the head of the user.

The head-mounted band 4210 is coupled to the display receiving casing 4220 and functions to mount the display receiving casing 4220 on the head of the user. As illustrated in FIG. 42, the head-mounted band 4210 may include a horizontal band and a vertical band for mounting the HMD 4200 to the head of the user. The horizontal band may enclose the sides of the head of the user, and the vertical band may enclose the top of the head of the user. However, embodiments of the disclosure are not limited to the foregoing embodiments. For example, the head-mounted band 4210 may be implemented in the form of an eyeglass frame or a helmet.

The display receiving casing 4220 may receive the display device (or display panel PNL; refer to FIG. 1). The display receiving case 4220 may include at least one lens. The lens may provide an image to the user. For example, the display device (or display panel PNL) in accordance with the aforementioned embodiments may be applied to a left-eye lens and a right-eye lens that are implemented in the display receiving case 4220.

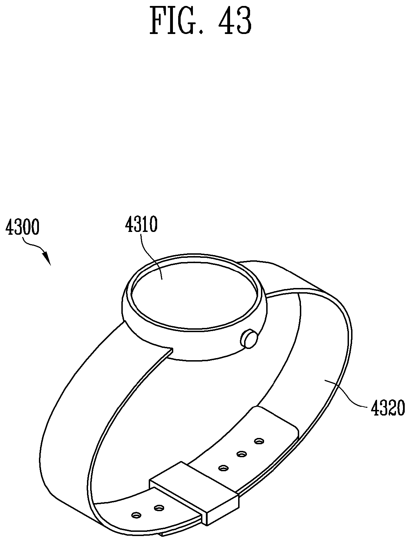

Referring to FIG. 43, the display device (or display panel PNL; refer to FIG. 1) in accordance with the aforementioned embodiments may be applied to a smart watch 4300. The smart watch 4300 may include a display component 4310 and a strap component 4320. The smart watch 4300 is a wearable electronic device. The strap component 4320 may be mounted to the wrist of the user. The display device in accordance with the aforementioned embodiments may be applied to the display component 4310. For example, the display device 4310 may provide image data including information such as time, date, and more.

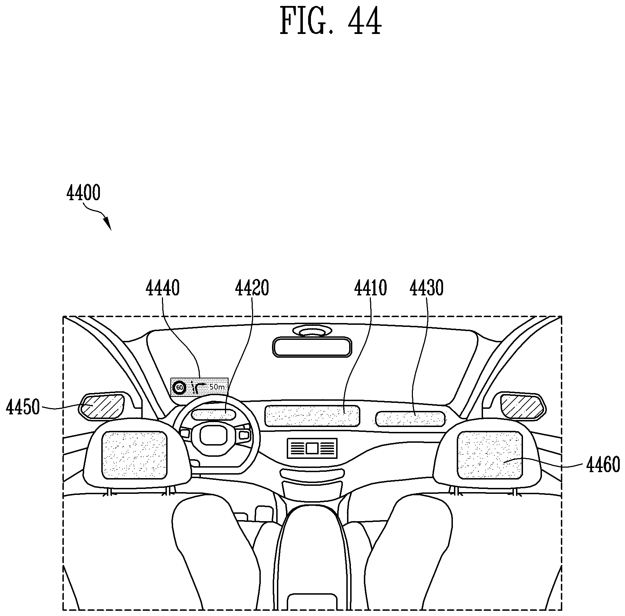

Referring to FIG. 44, the display device (or display panel PNL; refer to FIG. 1) in accordance with the aforementioned embodiments may be applied to an automotive display 4400. For example, the automotive display 4400 may be an electronic device which is provided inside and/or outside a vehicle to provide image data.

For example, the display device (or display panel PNL; refer to FIG. 1) in accordance with embodiments of the disclosure may be applied to at least one of an infortainment panel 4410, a cluster 4420, a co-driver display 4430, a head-up display 4440, a side mirror display 4450, and a rear seat display 4460, which may be provided in the vehicle.

Embodiments have been disclosed herein, and although terms are employed, they are used and are to be interpreted in a generic and descriptive sense only and not for purpose of limitation. In some instances, as would be apparent by one of ordinary skill in the art, features, characteristics, and/or elements described in connection with an embodiment may be used singly or in combination with features, characteristics, and/or elements described in connection with other embodiments unless otherwise specifically indicated. Accordingly, it will be understood by those of ordinary skill in the art that various changes in form and details may be made without departing from the spirit and scope of the disclosure.

## Claims

1. A display panel, comprising:
a substrate on which a first pixel that emits light in a first wavelength band, a second pixel that emits light in a second wavelength band, and a third pixel that emits light in a third wavelength band are disposed, each of the first to third pixels including a pixel circuit;
a first emission layer disposed on the substrate, and that emits light in the first wavelength band;
a second emission layer disposed on the first emission layer, and that emits light in the second wavelength band;
a third emission layer disposed on the second emission layer, and that emits light in the third wavelength band;
an a-th first electrode electrically connected to the pixel circuit of the first pixel, and electrically connected to the first emission layer in a first contact hole;
a b-th first electrode electrically connected to the pixel circuit of the second pixel, and electrically connected to the second emission layer in a second contact hole formed by removing at least a portion of the first emission layer;
a c-th first electrode electrically connected to the pixel circuit of the third pixel, and electrically connected to the third emission layer in a third contact hole formed by removing at least respective portions of the first and the second emission layers; and
a second electrode electrically connected to the pixel circuit of each of the first to the third pixels, and electrically connected to the first to the third emission layers in a fourth contact hole formed by removing at least respective portions of the first to the third emission layers.

2. The display panel according to claim 1, wherein
the first emission layer comprises:
a first semiconductor layer that provides electrons;
a second semiconductor layer that provides holes; and
an active layer disposed between the first semiconductor layer and the second semiconductor layer,
the first semiconductor layer is electrically connected to any one of the a-th first electrode and the second electrode, and
the second semiconductor layer is electrically connected to a remaining one of the a-th first electrode and the second electrode.

3. The display panel according to claim 2, wherein
a thickness of the first semiconductor layer is greater than a thickness of the second semiconductor layer,
the first semiconductor layer is electrically connected to the second electrode, and
the second semiconductor layer is electrically connected to the a-th first electrode.

4. The display panel according to claim 1, further comprising:
a passivation layer disposed on the substrate, and covering side surfaces of the a-th to the c-th first electrodes;
a first insulating layer disposed on the passivation layer;
a first transmissive conductive layer disposed between the passivation layer and the first emission layer, and electrically connected to the a-th first electrode in an area formed by removing at least a portion of the passivation layer;
a second insulating layer disposed on the second emission layer;
a second transmissive conductive layer disposed between the second insulating layer and the second emission layer, and electrically connected to the b-th first electrode in an area formed by removing at least a portion of the passivation layer;
a third insulating layer disposed on the second emission layer; and
a third transmissive conductive layer disposed between the third insulating layer and the third emission layer, and electrically connected to the c-th first electrode in an area formed by removing at least a portion of the passivation layer.

5. The display panel according to claim 4, further comprising:
a light blocking layer disposed in via holes enclosed by the passivation layer,
wherein the via holes comprise:
a first via hole disposed in an area formed by removing at least respective portions of the first insulating layer, the first transmissive conductive layer, the first emission layer, the second insulating layer, the second transmissive conductive layer, the second emission layer, the third insulating layer, the third transmissive conductive layer, and the third emission layer;
a second via hole disposed in an area formed by removing at least respective portions of the first insulating layer, the first transmissive conductive layer, the first emission layer, the second insulating layer, the second transmissive conductive layer, and the second emission layer; and
a third via hole disposed in an area formed by removing at least respective portions of the first insulating layer, the first transmissive conductive layer, the first emission layer.

6. The display panel according to claim 5, wherein the light blocking layer is formed through at least one of an electroplating process and a deposition process.

7. The display panel according to claim 6, wherein the light blocking layer is planarized on the passivation layer.

8. The display panel according to claim 1, wherein
the first wavelength band corresponds to a red wavelength band,
the second wavelength band corresponds to a green wavelength band, and
the third wavelength band corresponds to a blue wavelength band.

9. The display panel according to claim 4, wherein each of the first to the third insulating layers comprises an inorganic insulating layer.

10. A method of fabricating a display panel, the method comprising:
forming a third emission layer, a third transmissive conductive layer, a third insulating layer, a second emission layer, a second transmissive conductive layer, a second insulating layer, a first emission layer, a first transmissive conductive layer, and a first insulating layer on a temporary substrate;
forming a first via hole, a second via hole, and a third via hole in the first insulating layer, the first via hole exposing at least a portion of the third emission layer, the second via hole exposing at least a portion of the second emission layer, and the third via hole exposing at least a portion of the first emission layer;
forming a first passivation layer enclosing the first to the third via holes;
forming a first contact hole, a second contact hole, and a third contact hole in the first passivation layer, the first contact hole exposing at least a portion of the third transmissive conductive layer, the second contact hole exposing at least a portion of the second transmissive conductive layer, and the third contact hole exposing at least a portion of the first transmissive conductive layer;
forming a second passivation layer enclosing the first to the third contact holes;
removing the second passivation layer from areas corresponding to the first to the third contact holes;
forming a fourth contact hole in the second passivation layer;
forming a c-th first electrode in the first contact hole, forming a b-th first electrode in the second contact hole, forming an a-th first electrode in the first contact hole, and forming a second electrode in the second contact hole;
electrically connecting the a-th to c-th first electrodes and the second electrode to a pixel circuit of a substrate; and
removing the temporary substrate.

11. The method according to claim 10, wherein the forming of the first to the third via holes in the first insulating layer comprises:
forming a first photoresist layer including a first pattern on the first insulating layer;
forming a first via hole exposing at least a portion of the third emission layer in an area corresponding to the first pattern;
forming a second photoresist layer including a second pattern on the first insulating layer;
forming a second via hole exposing at least a portion of the second emission layer in an area corresponding to the second pattern;
forming a third photoresist layer including a third pattern on the first insulating layer; and
forming a third via hole exposing at least a portion of the first emission layer in an area corresponding to the third pattern.

12. The method according to claim 10, wherein the forming of the first to the third contact holes in the first passivation layer comprises:
forming a fourth photoresist layer including a fourth pattern on the first passivation layer;
forming a first contact hole exposing at least a portion of the third transmissive conductive layer in an area corresponding to the fourth pattern;
forming a fifth photoresist layer including a fifth pattern on the first passivation layer;
forming a second contact hole exposing at least a portion of the second transmissive conductive layer in an area corresponding to the fifth pattern;
forming a sixth photoresist layer including a sixth pattern on the first passivation layer; and
forming a third contact hole exposing at least a portion of the first transmissive conductive layer in an area corresponding to the sixth pattern.

13. The method according to claim 10, wherein the removing of the second passivation layer from areas corresponding to the first to the third contact holes comprises:
forming a seventh photoresist layer including a seventh pattern on the second passivation layer, the seventh pattern being formed by removing at least a portion of the seventh photoresist layer in areas corresponding to the first to the third contact holes; and
removing the second passivation layer from an area corresponding to the seventh pattern.

14. The method according to claim 10, wherein the forming of the fourth contact hole in the second passivation layer comprises:
forming an eighth photoresist layer including an eighth pattern on the second passivation layer; and
forming a fourth contact hole in an area corresponding to the eighth pattern.

15. The method according to claim 10, further comprising:
forming a light blocking layer in areas corresponding to the first to the third via holes in an area enclosed by the first passivation layer.

16. The method according to claim 15, wherein the light blocking layer is formed through a damascene process.

17. The method according to claim 15, wherein the light blocking layer is formed by at least one of a chemical vapor deposition method, a physical vapor deposition method, and an atomic layer deposition method.

18. The method according to claim 10, wherein the first passivation layer and the second passivation layer form a single passivation layer.

19. The method according to claim 10, wherein
the temporary substrate is a third temporary substrate, and
the forming of the third emission layer, the third transmissive conductive layer, the third insulating layer, the second emission layer, the second transmissive conductive layer, the second insulating layer, the first emission layer, the first transmissive conductive layer, and the first insulating layer on the temporary substrate comprises:
growing the first emission layer on a first temporary substrate;
growing the second emission layer on a second temporary substrate;
growing the third emission layer on the third temporary substrate;
forming a first intermediate insulating layer on the first emission layer;
forming a second intermediate insulating layer on the second emission layer;
forming a third intermediate insulating layer on the third emission layer;
forming a fourth intermediate insulating layer on a fourth temporary substrate;
forming a fifth intermediate insulating layer on a fifth temporary substrate;
forming the first insulating layer by bonding the first intermediate insulating layer and the fourth intermediate insulating layer to each other;
forming a sixth intermediate insulating layer by bonding the second intermediate insulating layer and the fifth intermediate insulating layer to each other;
removing the first temporary substrate;
removing the second temporary substrate;
forming a seventh intermediate insulating layer on the first emission layer;
forming an eighth intermediate insulating layer on the second emission layer;
forming the third insulating layer by bonding the third intermediate insulating layer and the eighth intermediate insulating layer to each other;
removing the fifth temporary substrate;
forming the first insulating layer by bonding the sixth intermediate insulating layer and the seventh intermediate insulating layer to each other; and
removing the fourth temporary substrate.

20. Smart glasses, comprising:
a lens component that displays an image; and
a frame that supports the lens component,
wherein the lens component comprises:
a substrate on which a first pixel that emits light in a first wavelength band, a second pixel that emits light in a second wavelength band, and a third pixel that emits light in a third wavelength band are disposed, each of the first to third pixels including a pixel circuit;
a first emission layer disposed on the substrate, and that emits light in the first wavelength band;
a second emission layer disposed on the first emission layer, and that emits light in the second wavelength band;
a third emission layer disposed on the second emission layer, and that emits light in the third wavelength band;
an a-th first electrode electrically connected to the pixel circuit of the first pixel, and electrically connected to the first emission layer in a first contact hole;
a b-th first electrode electrically connected to the pixel circuit of the second pixel, and electrically connected to the second emission layer in a second contact hole formed by removing at least a portion of the first emission layer;
a c-th first electrode electrically connected to the pixel circuit of the third pixel, and electrically connected to the third emission layer in a third contact hole formed by removing at least respective portions of the first and the second emission layers; and
a second electrode electrically connected to the pixel circuit of each of the first to the third pixels, and electrically connected to the first to the third emission layers in a fourth contact hole formed by removing at least respective portions of the first to the third emission layers.
